# EUROPEAN PATENT APPLICATION

(11) **EP 3 968 360 A1**
(43) Date of publication of application: **16.03.2022**
(21) Application number: 20802966.0
(22) Date of filing: 22.04.2020
(51) Int. Cl.: H01L 21/205, C23C 16/42, C23C 16/44

(54) **VAPOR PHASE GROWTH METHOD AND VAPOR PHASE GROWTH DEVICE**

(30) Priority: 08.05.2019 JP 2019088223
(71) Applicant: NuFlare Technology, Inc., Yokohama-shi, Kanagawa 235-8522 (JP)
(72) Inventor: MIZUSHIMA Ichiro, Yokohama-shi, Kanagawa 235-8522 (JP); ISHII Shigeaki, Yokohama-shi, Kanagawa 235-8522 (JP)
(74) Representative: Hoffmann Eitle
(86) International application number: PCT/JP2020/017333
(87) International publication number: WO 2020/226058

(57) **Abstract**

A vapor phase growth method of an embodiment is a vapor phase growth method using a vapor phase growth apparatus including a reactor, an exhaust pump for discharging a gas from the reactor, a pressure control valve for adjusting a pressure in the reactor, and an exhaust pipe having a first portion provided between the reactor and the pressure control valve and a second portion. The vapor phase growth method includes: loading a first substrate into the reactor, heating the first substrate to a predetermined temperature, supplying a process gas at a predetermined flow rate, and forming a silicon carbide film on a surface of the first substrate and depositing a by-product containing carbon in at least one of the first portion and the second portion by adjusting a pressure in the reactor to a predetermined pressure by controlling the pressure control valve; unloading the first substrate from the reactor; removing the by-product by supplying a gas including a gas containing fluorine to at least a part of the exhaust pipe by controlling a pressure in the exhaust pipe; and then loading a second substrate into the reactor to form a silicon carbide film on a surface of the second substrate.

## Description

### TECHNICAL FIELD

The present invention relates to a vapor phase growth method and a vapor phase growth apparatus for performing cleaning with a gas containing fluorine during vapor phase growth.

### BACKGROUND ART

In a vapor phase growth apparatus for forming a silicon carbide film, a process gas such as a raw material gas containing silicon (Si) or carbon (C) flows into a reactor to form a silicon carbide film on the surface of a substrate. An exhaust gas containing a process gas not consumed in the reactor or a gas generated by the reaction of the process gas is discharged from the reactor to the outside of the apparatus through an exhaust pipe, an exhaust pump, an abatement system, and the like.

The exhaust gas is condensed by being cooled as the exhaust gas passes through the exhaust pipe from the reactor, and accordingly, liquid or solid by-products are deposited on the inner surface of the exhaust pipe. There is a problem that the by-products cause clogging of the exhaust pipe.

If the exhaust pipe is blocked, maintenance work for the vapor phase growth apparatus is required, and the operating rate of the vapor phase growth apparatus is reduced. In addition, some by-products derived from the exhaust gas include substances that generate harmful gas or flammable substances, which may be dangerous for maintenance work. For this reason, a cleaning method for effectively removing by-products deposited in the exhaust pipe is required.

### CITATION LIST

### PATENT DOCUMENT

Patent Document 1: JP 2013-125810 A

### SUMMARY OF THE INVENTION

### PROBLEM TO BE SOLVED BY THE INVENTION

An object to be solved by the invention is to provide a vapor phase growth method and a vapor phase growth apparatus for effectively removing by-products deposited in an exhaust pipe.

### MEANS FOR SOLVING PROBLEM

A vapor phase growth method according to an aspect of the invention is a vapor phase growth method using a vapor phase growth apparatus including a reactor, an exhaust pump for discharging a gas from the reactor, a pressure control valve for adjusting a pressure in the reactor, and an exhaust pipe having a first portion provided between the reactor and the pressure control valve and a second portion provided between the pressure control valve and the exhaust pump. The vapor phase growth method includes: loading a first substrate into the reactor, heating the first substrate to a predetermined temperature, supplying a process gas at a predetermined flow rate, and forming a silicon carbide film on a surface of the first substrate and depositing a by-product containing carbon in at least one of the first portion and the second portion by adjusting a pressure in the reactor to a predetermined pressure by controlling the pressure control valve; unloading the first substrate from the reactor; removing the by-product by supplying a gas including a gas containing fluorine to at least a part of the exhaust pipe by controlling a pressure in the exhaust pipe; and loading a second substrate into the reactor to form a silicon carbide film on a surface of the second substrate after removing the by-product.

A vapor phase growth apparatus according to an aspect of the invention includes: a reactor; an exhaust pump for discharging a gas from the reactor; an exhaust pipe provided at least between the reactor and the exhaust pump; and a mechanism for moving a surface of a by-product deposited in the exhaust pipe.

A vapor phase growth apparatus according to another aspect of the invention includes: a reactor; an exhaust pump for discharging a gas from the reactor; an exhaust pipe provided at least between the reactor and the exhaust pump and including a storage portion for storing a by-product; and a heater for heating the storage portion.

### EFFECT OF THE INVENTION

According to the invention, it is possible to provide a vapor phase growth method and a vapor phase growth apparatus for effectively removing by-products deposited in the exhaust pipe.

### BRIEF DESCRIPTION OF DRAWINGS

Fig. 1 is a schematic diagram of an example of a vapor phase growth apparatus of a first embodiment;
Fig. 2 is an explanatory diagram of a vapor phase growth method of the first embodiment;
Fig. 3 is an explanatory diagram of the function and effect of the vapor phase growth method of the first embodiment;
Fig. 4 is an explanatory diagram of a vapor phase growth method of a modification example of the first embodiment;
Fig. 5 is a schematic diagram of an example of a vapor phase growth apparatus of a second embodiment;
Fig. 6 is an explanatory diagram of a vapor phase growth method of the second embodiment;
Fig. 7 is an explanatory diagram of the function and effect of the vapor phase growth method and the vapor phase growth apparatus of the second embodiment;
Fig. 8 is a schematic diagram of an example of a vapor phase growth apparatus of a third embodiment;
Fig. 9 is an explanatory diagram of a vapor phase growth method of the third embodiment;
Fig. 10 is a schematic diagram of an example of a vapor phase growth apparatus of a fourth embodiment;
Fig. 11 is a schematic cross-sectional view of a part of the vapor phase growth apparatus of the fourth embodiment;
Fig. 12 is an explanatory diagram of a vapor phase growth method of the fourth embodiment;
Fig. 13 is an explanatory diagram of the vapor phase growth method of the fourth embodiment;
Fig. 14 is a schematic diagram of an example of a vapor phase growth apparatus of a fifth embodiment;
Fig. 15 is an explanatory diagram of a vapor phase growth method of the fifth embodiment;
Fig. 16 is a schematic diagram of an example of a vapor phase growth apparatus of the fifth embodiment;
Fig. 17 is an explanatory diagram of a vapor phase growth method of a sixth embodiment;
Fig. 18 is a schematic diagram of an example of a vapor phase growth apparatus of a seventh embodiment;
Fig. 19 is an explanatory diagram of a vapor phase growth method of a seventh embodiment;
Fig. 20 is a schematic diagram of an example of a vapor phase growth apparatus of an eighth embodiment; and
Fig. 21 is an explanatory diagram of a vapor phase growth method of the eighth embodiment.

### MODE(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. In addition, "upper" means a position opposite to the direction of gravity with respect to the reference, and "upward" means a direction opposite to the direction of gravity with respect to the reference. In addition, "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

### (First Embodiment)

A vapor phase growth method of a first embodiment is a vapor phase growth method using a vapor phase growth apparatus including a reactor, an exhaust pump for discharging a gas from the reactor, a pressure control valve for adjusting a pressure in the reactor, and an exhaust pipe having a first portion provided between the reactor and the pressure control valve and a second portion provided between the pressure control valve and the exhaust pump. The vapor phase growth method includes: loading a first substrate into the reactor, heating the first substrate to a predetermined temperature, supplying a process gas at a predetermined flow rate, and forming a silicon carbide film on a surface of the first substrate and depositing a by-product containing carbon in at least one of the first portion and the second portion by adjusting a pressure in the reactor to a predetermined pressure by controlling the pressure control valve; unloading the first substrate from the reactor; removing the by-product by supplying a gas including a gas containing fluorine to at least a part of the exhaust pipe by controlling a pressure in the exhaust pipe; and loading a second substrate into the reactor to form a silicon carbide film on a surface of the second substrate after removing the by-product.

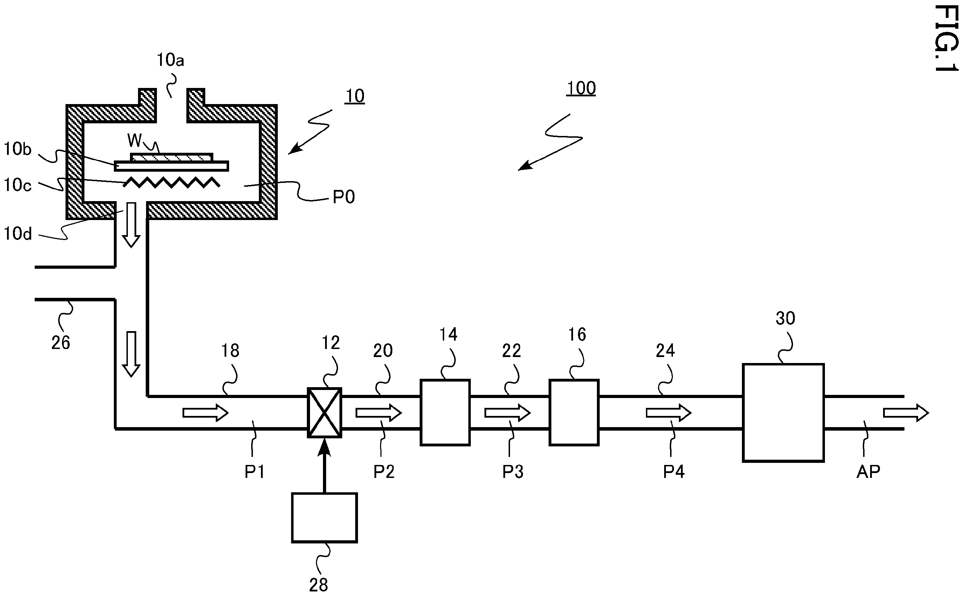

Fig. 1 is a schematic diagram of an example of the vapor phase growth apparatus of the first embodiment. An example of the vapor phase growth apparatus of the first embodiment is a vapor phase growth apparatus 100 for forming a silicon carbide film. The vapor phase growth apparatus 100 of the first embodiment is a vertical single wafer type epitaxial silicon carbide film vapor phase growth apparatus 100 that forms a film on each wafer.

The vapor phase growth apparatus 100 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, and a pressure control unit 28. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24.

The reactor 10 is formed of, for example, stainless steel. The reactor 10 has a cylindrical wall. A silicon carbide film is formed on the surface of a wafer W in the reactor 10. The wafer W is an example of a substrate.

The gas supply port 10a is provided at the upper part of the reactor 10. The process gas is supplied into the reactor 10 from the gas supply port 10a.

The process gas is, for example, a mixed gas containing a silicon (Si) source gas, a carbon (C) source gas, a dopant gas of n-type impurities, and a carrier gas. The silicon source gas is, for example, silane (SiH₄). The carbon source gas is, for example, propane (C₃H₈). The dopant gas of n-type impurities is, for example, nitrogen gas. The carrier gas is, for example, hydrogen gas or argon gas. In addition, an assist gas added for the purpose of achieving a high film formation speed by suppressing the clustering of silicon in the vapor phase may be added. The assist gas is a gas containing chlorine, for example, hydrogen chloride gas (HCl).

The wafer W can be placed on the susceptor 10b. An opening may be provided at the center of the susceptor 10b. The susceptor 10b is an example of a holder.

The heater 10c is provided below the susceptor 10b. The heater 10c heats the wafer W held by the susceptor 10b from below. The heater 10c is, for example, a resistor heater.

The gas exhaust port 10d is provided at the lower part of the reactor 10. Exhaust gas is exhausted from the gas exhaust port 10d. The exhaust gas contains a process gas not consumed in the reactor 10 or a gas generated by the reaction of the process gas.

As illustrated by the white arrows in Fig. 1, the exhaust gas is exhausted to the outside of the vapor phase growth apparatus 100 through the first exhaust pipe 18, the pressure control valve 12, the second exhaust pipe 20, the exhaust pump 14, the third exhaust pipe 22, the abatement system 16, and the fourth exhaust pipe 24. The exhaust gas is further exhausted through the exhaust duct 30, for example, to the outside of the building where the vapor phase growth apparatus 100 is installed. The outside of the exhaust duct 30 is atmospheric pressure.

The first exhaust pipe 18 is provided between the reactor 10 and the pressure control valve 12. The second exhaust pipe 20 is provided between the pressure control valve 12 and the exhaust pump 14. The third exhaust pipe 22 is provided between the exhaust pump 14 and the abatement system 16. The fourth exhaust pipe 24 is provided between the abatement system 16 and the exhaust duct 30.

Hereinafter, the pressure in the reactor 10 is referred to as a 0th pressure P0, the pressure in the first exhaust pipe 18 is referred to as a first pressure P1, the pressure in the second exhaust pipe 20 is referred to as second pressure P2, the pressure in the third exhaust pipe 22 is referred to as a third pressure P3, and the pressure in the fourth exhaust pipe 24 is referred to as a fourth pressure P4.

The exhaust pump 14 discharges a gas from the reactor 10. The exhaust pump 14 reduces the pressure in the reactor 10. The exhaust pump 14 is, for example, a vacuum pump.

The pressure control valve 12 adjusts the pressure in the reactor 10 to a desired pressure. The pressure control valve 12 adjusts the first pressure P1 in the first exhaust pipe 18. The pressure control valve 12 is, for example, a throttle valve. The pressure control valve 12 may be, for example, a butterfly valve.

The pressure control unit 28 controls, for example, the pressure control valve 12. For example, the opening degree of the pressure control valve 12 is changed by a command from the pressure control unit 28, so that the pressure in the reactor 10 or the first pressure P1 in the first exhaust pipe 18 are controlled.

The pressure P0 and the first pressure P1 in the reactor 10 are measured by, for example, a pressure gauge (not illustrated). For example, the pressure control unit 28 determines the opening degree of the pressure control valve 12, at which the pressure P0 or the first pressure P1 in the reactor 10 becomes a desired pressure, based on the result of the measured pressure P0 or first pressure P1 in the reactor 10. The pressure control unit 28 issues a command to the pressure control valve 12 so that the opening degree of the pressure control valve 12 becomes the determined opening degree.

The second pressure P2 is measured by, for example, a pressure gauge (not illustrated). For example, based on the measurement result of at least one of the measured pressure P0, first pressure P1, and second pressure P2 in the reactor 10, the exhaust speed of the exhaust pump 14 is determined so that at least one of the pressure P0, the first pressure P1, and the second pressure P2 in the reactor 10 becomes a desired pressure. The exhaust speed of the pump is controlled, for example, by the rotation speed of the rotor in the pump.

The abatement system 16 is provided between the exhaust pump 14 and the exhaust duct 30. The abatement system 16 is, for example, a combustion type abatement system. Alternatively, a dry (adsorption type) abatement system may be used.

The abatement system 16 detoxifies the exhaust gas exhausted from the reactor 10. The detoxified exhaust gas is discharged to the outside of the vapor phase growth apparatus 100.

The cleaning gas supply pipe 26 is connected to the first exhaust pipe 18. The cleaning gas supply pipe 26 supplies the cleaning gas to the first exhaust pipe 18. By the cleaning gas, by-products deposited in the first exhaust pipe 18, the second exhaust pipe 20, and the third exhaust pipe 22 are removed when a film is not formed in the reactor 10.

At this time, a purge gas such as nitrogen or argon flows into the reactor 10 from the gas supply port 10a to prevent the cleaning gas from flowing into the reactor 10. This is because, even if the temperature of the pipe rises to about 180°C due to exothermic reaction due to cleaning of by-products, the exhaust pipe mainly formed of metal is not etched, but there are members such as the susceptor 10b or the heater 10c in the reactor 10 that is easily etched by cleaning.

The cleaning gas may be supplied from the gas supply port 10a to the first exhaust pipe 18 through the inside of the reactor 10 when a film is not formed in the reactor 10. In this case, in addition to the by-products deposited in the first exhaust pipe 18, the second exhaust pipe 20, and the third exhaust pipe 22, the by-products deposited in the reactor 10 are removed. In this case, in order to avoid etching of members that are easily etched by cleaning, such as the susceptor 10b or the heater 10c in the reactor 10, it is necessary to control the flow rate of the etching gas and the like so that the temperature in the reactor 10 does not rise to, for example, 100°C or higher.

The cleaning gas includes a gas containing fluorine. The cleaning gas includes, for example, chlorine trifluoride (ClF₃) gas or fluorine (F₂). The cleaning gas may be, for example, a single gas of trifluorinated chlorine gas or a mixed gas containing another gas. The cleaning gas is, for example, a mixed gas of trifluorinated chlorine gas and nitrogen gas, or a mixed gas of trifluorinated chlorine gas and argon gas.

The exhaust duct 30 is provided outside the vapor phase growth apparatus 100. The exhaust duct 30 is connected to the fourth exhaust pipe 24. Due to the exhaust duct 30, the third pressure P3 in the third exhaust pipe 22 and the fourth pressure P4 in the fourth exhaust pipe 24 are maintained at about atmospheric pressure or negative pressure with respect to the atmospheric pressure.

Next, a vapor phase growth method of the first embodiment will be described. The case of forming a silicon carbide film on the wafer W by epitaxial growth will be described as an example.

The vapor phase growth method of the first embodiment is a vapor phase growth method for cleaning by-products generated with the formation of a silicon carbide film.

First, the wafer W (first substrate) is loaded into the reactor 10 and placed on the susceptor 10b. The wafer W is heated by the heater 10c. The wafer W is heated to a predetermined temperature. The wafer W is heated to, for example, 1600°C.

A predetermined flow rate of process gas is supplied into the reactor 10 from the gas supply port 10a. The process gas is, for example, a mixed gas of silane (SiH₄), propane (C₃H₈), nitrogen gas, and hydrogen gas. In addition, hydrogen chloride gas (HCl) may be added.

While supplying the process gas into the reactor 10, the pressure in the reactor 10 is kept low by using the exhaust pump 14. The inside of the reactor 10 is decompressed. The pressure in the reactor 10 is adjusted to a predetermined pressure, such as 200 Torr, by using the pressure control valve 12.

A silicon carbide film is formed on the surface of the wafer W by epitaxial growth.

During the growth of the silicon carbide film, the exhaust gas is exhausted to the outside of the vapor phase growth apparatus 100 through the first exhaust pipe 18, the pressure control valve 12, the second exhaust pipe 20, the exhaust pump 14, the third exhaust pipe 22, the abatement system 16, and the fourth exhaust pipe 24, as illustrated by the white arrows in Fig. 1. The exhaust gas is further exhausted through the exhaust duct 30, for example, to the outside of the building where the vapor phase growth apparatus 100 is installed.

The exhaust gas contains a process gas not consumed in the reactor 10 or a gas generated by the reaction of the process gas. The exhaust gas is condensed by being cooled as the exhaust gas passes through the first exhaust pipe 18, the second exhaust pipe 20, and the third exhaust pipe 22 from the reactor 10, so that liquid or solid by-products are deposited on the inner surfaces of the first exhaust pipe 18, the second exhaust pipe 20, and the third exhaust pipe 22.

A silicon carbide film is formed on the surface of the wafer W, and carbon-containing by-products are deposited at least on the upstream side or the downstream side of the pressure control valve 12. A silicon carbide film is formed on the surface of the wafer W, and carbon-containing by-products are deposited on at least one of the first exhaust pipe 18 and the second exhaust pipe 20.

By-products include, for example, polymer compounds containing silicon (Si) and hydrogen (H). In addition, chlorine (Cl) may be contained. Polymer compounds containing silicon (Si) and hydrogen (H) are highly flammable substances. When chlorine (Cl) is further contained, the polymer compound is called oily silane, which is also a highly flammable substance.

After forming the silicon carbide film on the surface of the wafer W, the wafer W is unloaded to the outside of the reactor 10.

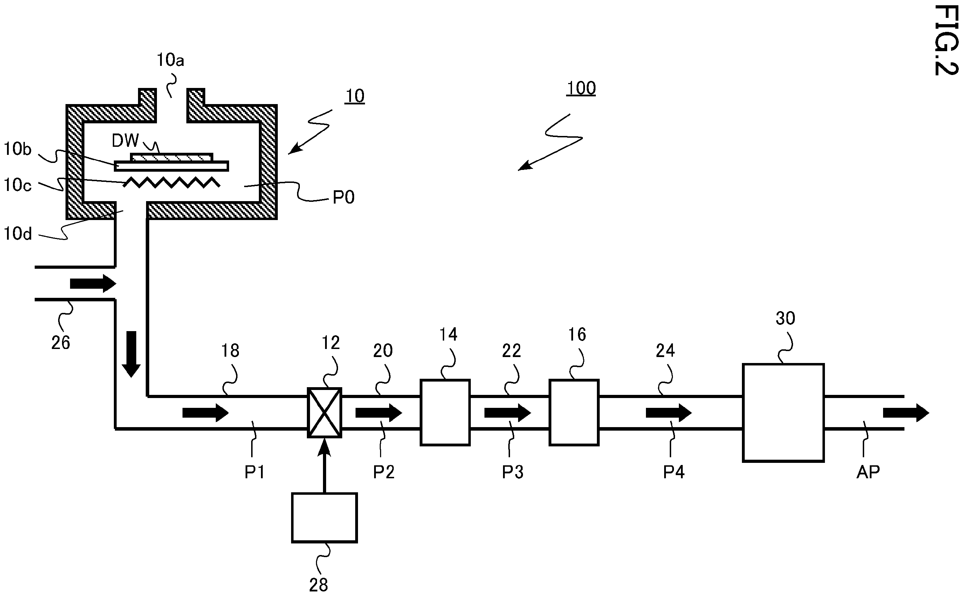

Fig. 2 is an explanatory diagram of the vapor phase growth method of the first embodiment.

The wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen, and its flow rate is, for example, 500 sccm for nitrogen and 100 sccm for chlorine trifluoride. The purge gas is, for example, nitrogen gas or argon gas, and its flow rate is, for example, 500 sccm.

While supplying the cleaning gas, the pressure in the reactor 10, the first exhaust pipe 18, and the second exhaust pipe 20 is kept low by using the exhaust pump 14. The inside of the reactor 10, the first exhaust pipe 18, and the second exhaust pipe 20 is decompressed. The pressure in the reactor 10 is, for example, 100 Torr, the first pressure P1 in the first exhaust pipe 18 is, for example, 10 Torr, and the second pressure P2 in the second exhaust pipe 20 is, for example, 1.0 Torr.

Alternatively, the wafer W is unloaded to the outside of the reactor 10, and then the dummy wafer DW is loaded into the reactor 10 and placed on the susceptor 10b. Then, the cleaning gas is supplied from the gas supply port 10a into the first exhaust pipe 18 through the reactor 10. The cleaning gas is, for example, chlorine trifluoride (ClF₃) gas diluted with nitrogen. The flow rate is, for example, 1 slm for nitrogen and 100 sccm for chlorine trifluoride.

While supplying the cleaning gas, the pressure in the reactor 10, the first exhaust pipe 18, and the second exhaust pipe 20 is kept low by using the exhaust pump 14. The inside of the reactor 10, the first exhaust pipe 18, and the second exhaust pipe 20 is decompressed. The pressure in the reactor 10 is, for example, 100 Torr, the first pressure P1 in the first exhaust pipe 18 is, for example, 50 Torr, and the second pressure P2 in the second exhaust pipe 20 is, for example, 1.5 Torr.

In addition, due to the exhaust by the exhaust duct 30, the pressure in the third exhaust pipe 22 and the fourth exhaust pipe 24 is maintained at about atmospheric pressure or lower than the atmospheric pressure. The pressure in the third exhaust pipe 22 and the fourth exhaust pipe 24 becomes about atmospheric pressure or negative pressure with respect to the atmospheric pressure. The third pressure P3 in the third exhaust pipe 22 is, for example, 95% or more of the atmospheric pressure.

As illustrated by the black arrow in Fig. 2, the cleaning gas is exhausted to the outside of the vapor phase growth apparatus 100 through the first exhaust pipe 18, the pressure control valve 12, the second exhaust pipe 20, the exhaust pump 14, the third exhaust pipe 22, the abatement system 16, and the fourth exhaust pipe 24. The cleaning gas is further exhausted through the exhaust duct 30, for example, to the outside of the building where the vapor phase growth apparatus 100 is installed.

Assuming that the pressure in the reactor 10 is the 0th pressure P0, the pressure in the first exhaust pipe 18 is the first pressure P1, the pressure in the second exhaust pipe 20 is the second pressure P2, the pressure in the third exhaust pipe 22 is the third pressure P3, the pressure in the fourth exhaust pipe 24 is the fourth pressure P4, and the atmospheric pressure is the atmospheric pressure AP, the following relationship is maintained during cleaning with the cleaning gas.
P0 > P1 > P2

In addition, the first pressure P1 is controlled to be, for example, 10 Torr or more and 50 Torr or less, and the second pressure P2 is controlled to be, for example, 1 Torr or more and 5 Torr or less. These pressures are controlled by adjusting the opening degree of the pressure control valve 12 according to a command from the pressure control unit 28.

At this time, for example, the pressure P0 and the first pressure P1 in the reactor 10 are measured with a pressure gauge (not illustrated). The opening degree of the pressure control valve 12 is adjusted based on the results of the measured pressure P0 and first pressure P1 in the reactor 10.

For example, the pressure control unit 28 determines the opening degree of the pressure control valve 12, at which the pressure P0 and the first pressure P1 in the reactor 10 become desired pressures, based on the results of the measured pressure P0 and first pressure P1 in the reactor 10. The pressure control unit 28 issues a command to the pressure control valve 12 so that the opening degree of the pressure control valve 12 becomes the determined opening degree.

In addition, for example, the pressure P0, the first pressure P1, and the second pressure P2 in the reactor 10 are measured with a pressure gauge (not illustrated). The exhaust speed of the exhaust pump 14 is adjusted based on the results of the measured pressure P0 and first pressure P1 in the reactor 10.

The exhaust speed of the exhaust pump 14 determines, for example, the number of rotations of a rotor in the exhaust pump at which the 0th pressure P0, the first pressure P1, and the second pressure P2 in the reactor 10 become predetermined pressures, for example, based on the results of the measured pressure P0, first pressure P1, and second pressure P2 in the reactor 10.

In addition, for example, the third pressure P3 is controlled to be 95% or more of the atmospheric pressure. By adjusting the exhaust amount by the exhaust duct 30, the third pressure P3 is controlled to be 95% or more of the atmospheric pressure AP.

By the cleaning gas, by-products deposited in the first exhaust pipe 18, the second exhaust pipe 20, and the third exhaust pipe 22 are removed. In addition, when the cleaning gas flows into the reactor 10, by-products in the reactor 10 are also removed.

While the cleaning gas is being supplied, the walls of the first exhaust pipe 18, the second exhaust pipe 20, and the third exhaust pipe 22 generate heat due to the reaction between the cleaning gas and the by-products, but the temperature is maintained at, for example, 180°C or lower. While the cleaning gas is being supplied, the walls of the first exhaust pipe 18, the second exhaust pipe 20, and the third exhaust pipe 22 are not necessarily actively heated from the outside.

After removing the by-products deposited in the first exhaust pipe 18, the second exhaust pipe 20, and the third exhaust pipe 22 with the cleaning gas, the wafer W (second substrate) is loaded into the reactor 10 to form a silicon carbide film on the surface of the wafer W.

Next, the function and effect of the vapor phase growth method of the first embodiment will be described.

In a vapor phase growth apparatus for forming a silicon carbide film, a process gas such as a raw material gas containing silicon (Si) or carbon (C) flows into a reactor to form a silicon carbide film on the surface of a substrate. An exhaust gas containing a process gas not consumed in the reactor or a gas generated by the reaction of the process gas is discharged from the reactor to the outside of the apparatus through an exhaust pipe, an exhaust pump, an abatement system, and the like.

The exhaust gas is condensed by being cooled as the exhaust gas passes through the exhaust pipe from the reactor, so that liquid or solid by-products are deposited on the inner surface of the exhaust pipe. There is a problem that the by-products cause clogging of the exhaust pipe.

If the exhaust pipe is blocked, maintenance work for the vapor phase growth apparatus is required, and the operating rate of the vapor phase growth apparatus is reduced. In addition, some by-products of exhaust gas include substances that generate harmful gas or flammable substances, which may be dangerous for maintenance work. For this reason, a cleaning method for effectively removing by-products deposited in the exhaust pipe is required.

For example, when epitaxially growing a silicon film on the surface of the substrate, a gas containing silane (SiH₄) may be used as a process gas. In this case, it is known that a polymer compound, which is a highly flammable substance containing silicon (Si) and hydrogen (H), is deposited as a by-product in the exhaust pipe of the vapor phase growth apparatus. In addition, when chlorine (Cl) is contained as a process gas, it is known that a polymer compound containing silicon (Si), hydrogen (H), and chlorine (Cl) is deposited as a by-product. In addition, a polymer compound containing chlorine (Cl) is called oily silane, which is also a highly flammable substance.

The polymer compound containing silicon (Si), hydrogen (H), and chlorine (Cl) can be removed by chlorine trifluoride (ClF₃) gas.

For example, when epitaxially growing a silicon carbide film on the surface of the substrate, a gas containing silane (SiH₄) and chlorine (Cl) may be used as a process gas. In this case as well, as in the case of the silicon film, a polymer compound containing silicon (Si) and hydrogen (H) is deposited as a by-product in the exhaust pipe of the vapor phase growth apparatus. In addition, the process gas may further contain chlorine (Cl). In this case, a polymer compound containing silicon (Si), hydrogen (H), and chlorine (Cl) is deposited as a by-product in the exhaust pipe of the vapor phase growth apparatus.

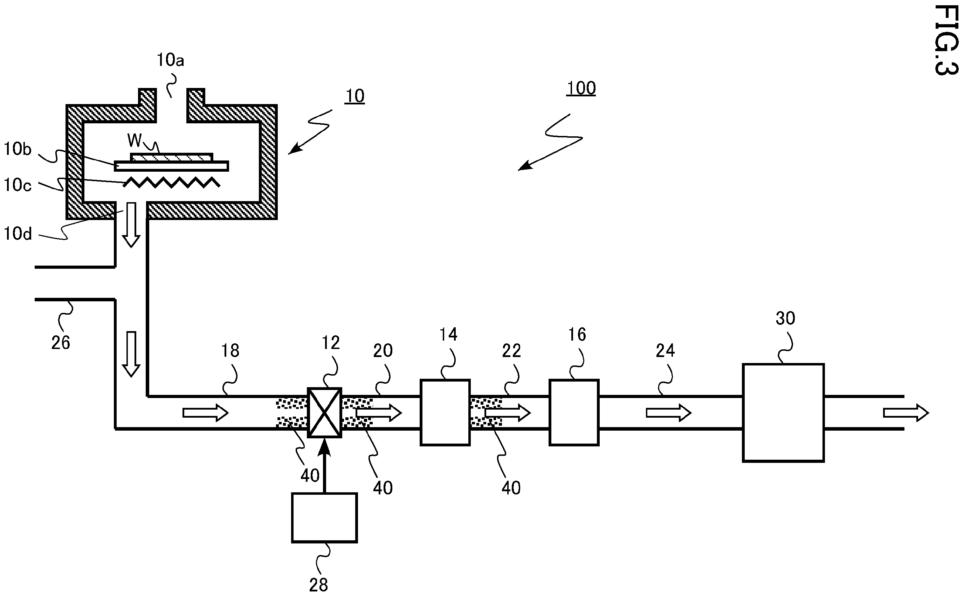

Fig. 3 is an explanatory diagram of the function and effect of the vapor phase growth method of the first embodiment.

The inventor compared the by-product when the silicon film is epitaxially grown with the by-product when the silicon carbide film is epitaxially grown. As a result, it has been clarified that a large amount of low molecular weight compounds having a mass number of 200 or less are contained in the case of the silicon carbide film. In addition, it has been clarified that carbon is contained in the low molecular weight compounds. The carbon is considered to be derived from, for example, propane (C₃H₈), which is a source gas of carbon in the silicon carbide film.

Low molecular weight compounds containing carbon are, for example, CH₄, C₂H₆, C₃H₈, CH₃Cl, CH₂Cl₂, CHCl₃, CCl₄, C₂H₅Cl, C₂H₄Cl₂, C₂H₃Cl₃, C₂H₂Cl₄, C₂HCl₅, C₂Cl₆, C₂H₄Cl, C₂H₃Cl, C₂H₂Cl, C₂HCl, C₃H₇Cl, C₃H₆Cl, C₃H₅Cl, C₃H₄Cl, C₃H₃Cl, C₃H₂Cl, C₃HCl, C₃H, and C₃Cl.

In addition, the inventor examined the deposition location of by-products when epitaxially growing the silicon carbide film. As a result, as illustrated in Fig. 3, it has been clarified that a large amount of by-products 40 are deposited near the pressure control valve 12 in the first exhaust pipe 18 on the upstream side of the pressure control valve 12, near the pressure control valve 12 in the second exhaust pipe 20 on the downstream side of the pressure control valve 12, and in the third exhaust pipe 22 on the downstream side of the exhaust pump 14. For example, the deposition location of by-products when epitaxially growing the silicon film is a location, which is away from the reactor 10 and at which the temperature does not rise at the time of film formation, mainly in the first exhaust pipe 18 on the upstream side of the pressure control valve 12.

When epitaxially growing the silicon carbide film, unlike in a case where the silicon film is epitaxially grown, the exhaust gas discharged from the reactor contains carbon, which is an atom lighter than silicon. For this reason, even if the saturated vapor pressure of the exhaust gas becomes high and the exhaust gas flows into the exhaust pipe from the reactor that is hot, this is not easily liquefied or solidified. The difference in the deposition location of by-products is considered to be caused by the above difference.

The second pressure P2 in the second exhaust pipe 20 is lower than the first pressure P1 in the first exhaust pipe 18 since the gas flow path is narrowed by the pressure control valve 12. For this reason, when the exhaust gas passes through the pressure control valve 12, the temperature drops at once due to the adiabatic expansion. Therefore, it is considered that by-products are formed on the downstream side of the pressure control valve 12.

The reason why the by-products are generated near the pressure control valve 12 in the first exhaust pipe 18 on the upstream side of the pressure control valve 12 and near the pressure control valve 12 in the second exhaust pipe 20 on the downstream side of the pressure control valve 12 is considered that the by-products generated in the pressure control valve 12 have flowed to the upstream side and the downstream side of the pressure control valve 12.

In the vapor phase growth method of the first embodiment, when supplying the cleaning gas, the first pressure P1 in the first exhaust pipe 18 on the upstream side of the pressure control valve 12 is controlled to be 1 Torr or more and 700 Torr or less.

That is, the first pressure P1 is maintained at a relatively high pressure. By maintaining the first pressure P1 at a relatively high pressure, the reaction between the cleaning gas and the by-product 40 is promoted. Therefore, it is possible to effectively remove the by-product 40 in the first exhaust pipe 18 on the upstream side of the pressure control valve 12.

From the viewpoint of effectively removing by-products in the first exhaust pipe 18 on the upstream side of the pressure control valve 12, the first pressure P1 is preferably 10 Torr or more.

In addition, in the vapor phase growth method of the first embodiment, when supplying the cleaning gas, the second pressure P2 in the second exhaust pipe 20 on the downstream side of the pressure control valve 12 is controlled to be 0.1 Torr or more and 100 Torr or less.

That is, the second pressure P2 is maintained at a relatively high pressure. By maintaining the second pressure P2 at a relatively high pressure, the reaction between the cleaning gas and the by-product 40 is promoted. Therefore, it is possible to effectively remove the by-product 40 in the second exhaust pipe 20 on the downstream side of the pressure control valve 12.

From the viewpoint of effectively removing by-products in the second exhaust pipe 20 on the downstream side of the pressure control valve 12, the second pressure P2 is preferably 1 Torr or more.

From the viewpoint of effectively removing by-products in the second exhaust pipe 20 on the downstream side of the pressure control valve 12, the second pressure P2 is preferably controlled to be 1% or more of the first pressure P1, more preferably controlled to be 5% or more of the first pressure P1, and even more preferably controlled to be 10% or more of the first pressure P1.

In addition, when epitaxially growing the silicon carbide film, it has been clarified that a considerable amount of by-products 40 are also deposited in the third exhaust pipe 22 between the exhaust pump 14 and the abatement system 16 as illustrated in Fig. 3. The reason why the by-products are found in the third exhaust pipe 22 on the downstream side of the exhaust pump 14 is considered that the exhaust gas is compressed inside the exhaust pump 14 and the by-products are polymerized to be easily liquefied or solidified. In the vapor phase growth method of the first embodiment, for example, when supplying the cleaning gas, the third pressure P3 in the third exhaust pipe 22 is controlled to be 95% or more of the atmospheric pressure.

That is, the third pressure P3 is maintained at a relatively high pressure. By maintaining the third pressure P3 at a relatively high pressure, the reaction between the cleaning gas and the by-product is promoted. Therefore, it is possible to effectively remove the by-product 40 in the third exhaust pipe 22.

From the viewpoint of effectively removing by-products in the third exhaust pipe 22, the third pressure P3 in the third exhaust pipe 22 is preferably 98% or more of the atmospheric pressure, more preferably 99% or more of the atmospheric pressure.

When supplying the cleaning gas, it is preferable to monitor the 0th pressure P0, the first pressure P1, and the second pressure P2 in the reactor and feed back the monitoring result as the opening degree of the pressure control valve 12 and the exhaust speed of the exhaust pump 14. Since the second pressure P2 becomes stable, by-products in the third exhaust pipe 22 can be stably removed.

While the cleaning gas is being supplied, the temperature of the walls of the first exhaust pipe 18, the second exhaust pipe 20, and the third exhaust pipe 22 is preferably maintained at 180°C or lower. In addition, it is preferable that the walls of the first exhaust pipe 18, the second exhaust pipe 20, and the third exhaust pipe 22 are not heated from the outside while the cleaning gas is being supplied.

A low molecular weight compound containing carbon has higher reactivity with a gas containing fluorine and a larger amount of heat generated during the reaction than, for example, a polymer compound containing silicon (Si), hydrogen (H), and chlorine (Cl). Therefore, reaction by-products containing low molecular weight compounds containing carbon can be removed at lower temperatures than, for example, reaction by-products containing only polymer compounds containing silicon (Si), hydrogen (H) and chlorine (Cl). For this reason, cleaning can be performed efficiently without necessarily performing heating from the outside.

The inventor examined the gas exhausted when performing a cleaning process with chlorine trifluoride (ClF₃) gas. As a result, it has been found that, in addition to SiF₄, SiF₃, Cl₂, Si₂F₆, and Si₂F₅ contained when cleaning reaction by-products containing only polymer compounds containing silicon (Si), hydrogen (H), and chlorine (Cl), CF₄, CF₃Cl, CF₂Cl₂, CFCl₃, CCl₄, CHF₃, CHF₂Cl, CHFCl₂, C₂H₅F, C₂H₄F₂, C₂H₃F₃, C₂H₂F₄, C₂H₃F₂, C₂H₂F, C₂H₂F₃, C₂H₂F₂, C₂H₂F, C₃H₇F, C₃H₆F₂, C₃H₅F₃, C₃H₅F, C₃H₅F₂, C₃H₄F, C₃H₄F₂, C₄H₉F, C₄H₈F₂, C₄H₇F₃, C₄H₆F₄, C₄H₅F₅, C₄H₈F, C₄H₇F₂, C₄H₆F₃, C₄H₅F₄, C₄H₄F₅, C₄H₇F, C₄H₆F₂, C₄H₅F₃, C₄H₄F₄, C₄H₃F₅, C₄H₆F, C₄H₅F₂, C₄H₄F₃, C₅H₃F₂, C₅H₃F₆, and the like that are gases containing C are contained. These compounds are produced as a result of the by-product 40 containing a compound containing carbon (C). By producing such a compound containing both carbon and fluorine (F) during cleaning, the amount of heat generated by the chemical reaction during cleaning increases, so that it is possible to perform effective cleaning without performing heating from the outside of the pipe.

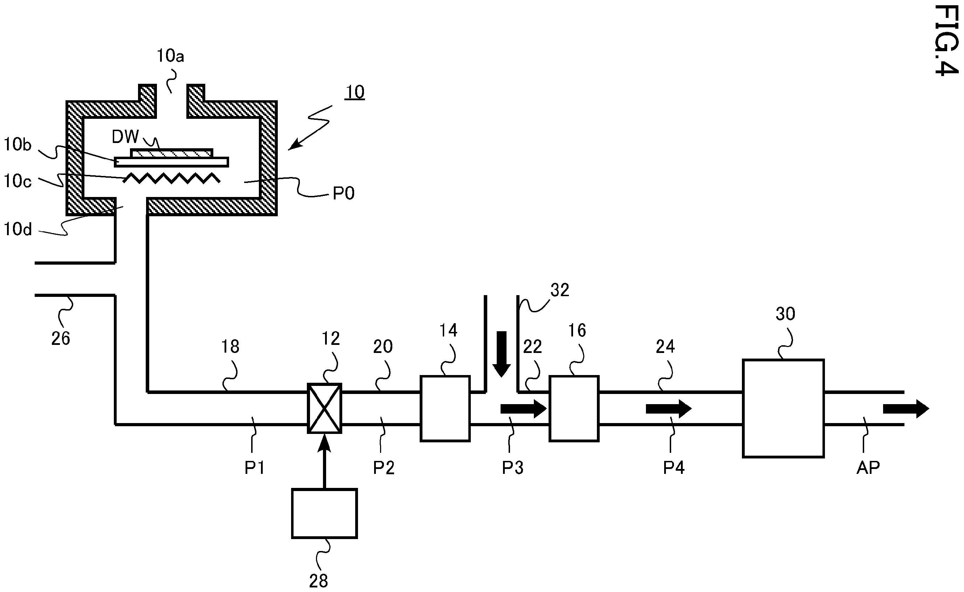

Fig. 4 is an explanatory diagram of a vapor phase growth method of a modification example of the first embodiment. In the modification example, a vapor phase growth apparatus having a cleaning gas supply pipe 32 connected to the third exhaust pipe 22 is used.

As illustrated in Fig. 4, the cleaning gas supply pipe 32 is provided for the third exhaust pipe 22, so that the cleaning gas (black arrow in Fig. 4) flows from the cleaning gas supply pipe while flowing the purge gas from the upstream exhaust pump 14 side. In this manner, it is also possible to effectively remove by-products in the third exhaust pipe 22 between the exhaust pump 14 and the abatement system 16.

As described above, according to the vapor phase growth methods of the first embodiment and the modification example, it is possible to effectively remove by-products deposited in the exhaust pipe at the time of forming the silicon carbide film.

### (Second Embodiment)

A vapor phase growth method of a second embodiment is different from the vapor phase growth method of the first embodiment in that the surface of by-products moves when the by-products are removed. In the vapor phase growth method of the second embodiment, the surface of by-products is moved by vibrating a first portion when removing the by-products. In the vapor phase growth method of the second embodiment, when removing the by-products, the first portion is hit from the outside to give an impact to the first portion so that the pipe vibrates quickly. An impact is given to the first portion to move the first portion.

A vapor phase growth apparatus of the second embodiment includes a reactor, an exhaust pump for discharging a gas from the reactor, an exhaust pipe provided at least between the reactor and the exhaust pump, and a mechanism for moving the surface of by-products deposited in the exhaust pipe. The vapor phase growth apparatus of the second embodiment is different from the vapor phase growth apparatus of the first embodiment in that the mechanism for moving the surface of by-products deposited in the exhaust pipe is provided. The mechanism for moving the surface of by-products deposited in the exhaust pipe is a vibration device that vibrates the exhaust pipe by hitting. The mechanism for moving the surface of by-products deposited in the exhaust pipe is a vibration device that moves the exhaust pipe by hitting.

Hereinafter, the description of a part of the content overlapping the first embodiment will be omitted.

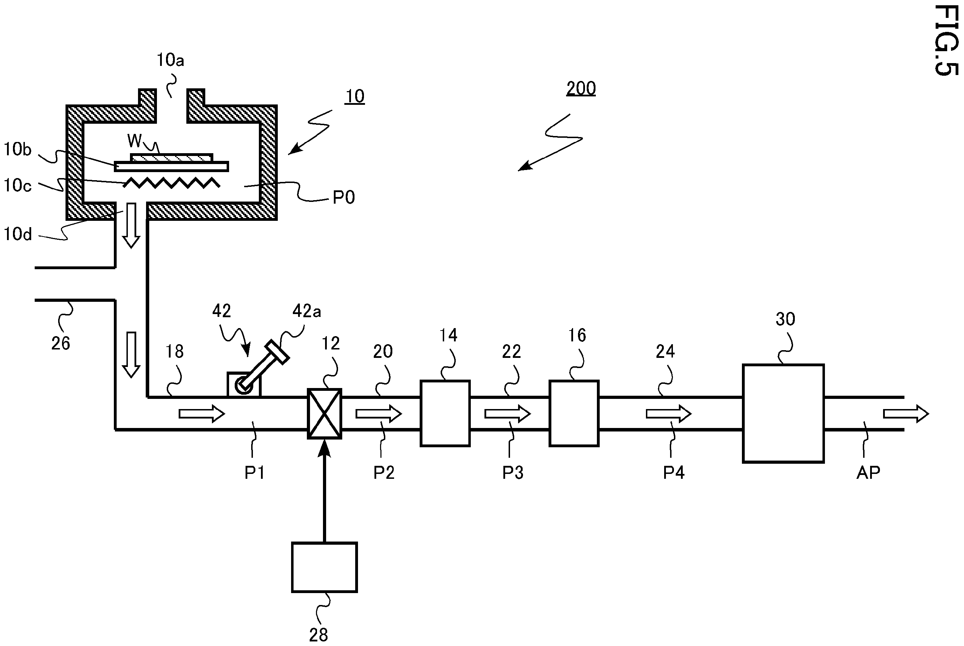

Fig. 5 is a schematic diagram of an example of the vapor phase growth apparatus of the second embodiment. An example of the vapor phase growth apparatus of the second embodiment is a vapor phase growth apparatus 200 for forming a silicon carbide film. The vapor phase growth apparatus 200 of the second embodiment is a vertical single wafer type epitaxial silicon carbide film vapor phase growth apparatus 200 that forms a film on each wafer.

The vapor phase growth apparatus 200 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, a pressure control unit 28, and a vibration device 42. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24.

The vibration device 42 has a function of hitting the first exhaust pipe 18 from the outside. The vibration device 42 hits the first exhaust pipe 18 at a predetermined period and with a predetermined weight, for example. The vibration device 42 hits the first exhaust pipe 18 from the outside by using a hammer portion 42a provided in the vibration device 42.

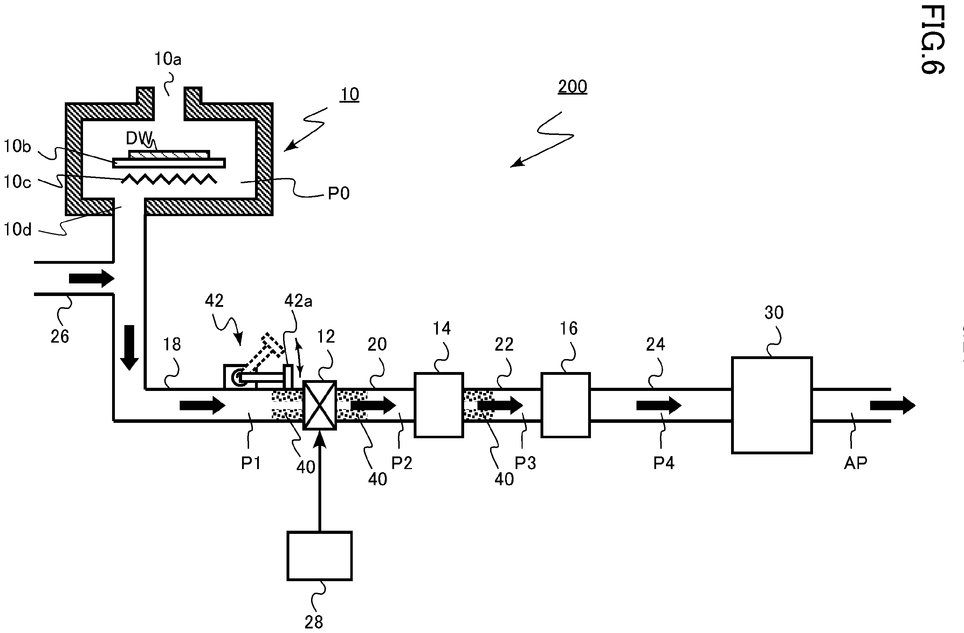

Fig. 6 is an explanatory diagram of the vapor phase growth method of the second embodiment.

In the vapor phase growth method of the second embodiment, similar to the vapor phase growth method of the first embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

In the vapor phase growth method of the second embodiment, the first exhaust pipe 18 is hit from the outside by using the vibration device 42 while supplying the cleaning gas. The hammer portion 42a of the vibration device 42 hits the first exhaust pipe 18 at a predetermined period and with a predetermined weight, for example.

By hitting the first exhaust pipe 18 from the outside using the vibration device 42 while supplying the cleaning gas, the first exhaust pipe 18 moves. By hitting the first exhaust pipe 18 from the outside, for example, the first exhaust pipe 18 vibrates.

By hitting the first exhaust pipe 18 from the outside using the vibration device 42, the surface of the by-product 40 deposited in the first exhaust pipe 18 moves. By hitting the first exhaust pipe 18 from the outside using the vibration device 42, for example, the surface of the by-product 40 vibrates.

In the vapor phase growth method of the second embodiment, the first exhaust pipe 18 is hit from the outside by using the vibration device 42 while supplying the cleaning gas, so that the surface of the by-product 40 deposited in the first exhaust pipe 18 moves. The movement of the surface of the by-product 40 deposited in the first exhaust pipe 18 promotes the reaction between the cleaning gas and the by-product 40. Therefore, the by-product 40 deposited in the first exhaust pipe 18 can be effectively removed.

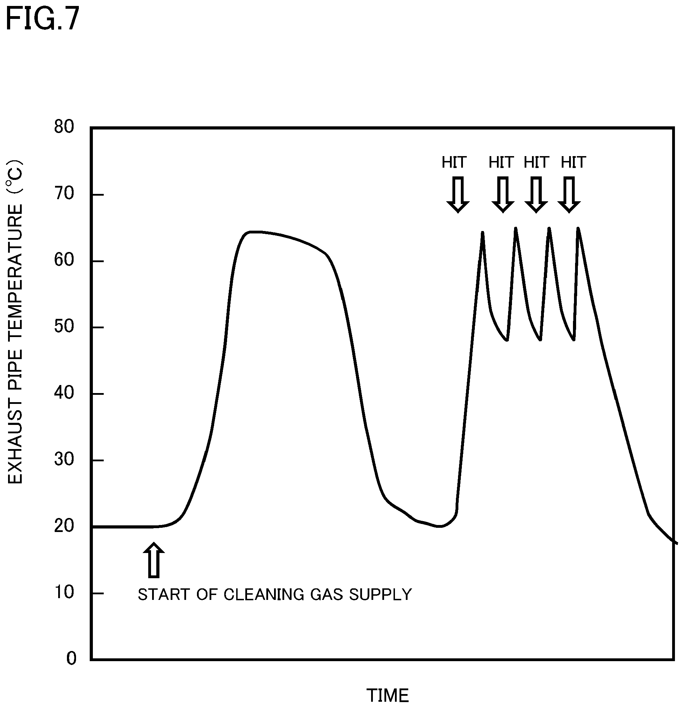

Fig. 7 is an explanatory diagram of the function and effect of the vapor phase growth method and the vapor phase growth apparatus of the second embodiment. Fig. 7 shows a change in exhaust pipe temperature with time in a state in which a cleaning gas is supplied to the exhaust pipe of the vapor phase growth apparatus 200.

As shown in Fig. 7, the temperature of the exhaust pipe rises as the supply of the cleaning gas to the exhaust pipe starts . The rise in the temperature of the exhaust pipe is due to the generation of heat of reaction between the cleaning gas and by-products.

The temperature of the exhaust pipe rises and then drops. Thereafter, when the exhaust pipe is hit, the temperature of the exhaust pipe rises again. When the temperature of the exhaust pipe starts to drop again and then the exhaust pipe is hit again, the temperature of the exhaust pipe rises again.

The temperature change of the exhaust pipe observed in Fig. 7 is explained as follows. When the cleaning gas is supplied to the exhaust pipe, the cleaning gas reacts with the surface of by-products, and the removal of by-products starts. As the reaction between the cleaning gas and the surface of by-products proceeds, a coat that inhibits the reaction between the cleaning gas and the by-products is formed on the surface of the by-products. When a coat is formed on the surface of the by-products, the reaction is suppressed. Therefore, since the generation of heat of reaction is suppressed, the temperature of the exhaust pipe drops.

The coat formed on the surface of by-products is considered to be a substance having a carbon-carbon bond. The inventor's Raman spectroscopic analysis on the residue has revealed that a substance having a carbon-carbon bond is present in the residue of the by-products after cleaning.

By hitting the exhaust pipe, the surface of the by-products moves. By hitting the exhaust pipe, the coat on the surface of the by-products moves. Due to the movement of the coat on the surface of the by-products, the coat is split and the by-products are exposed between the pieces of the coat. The exposed by-products react with the cleaning gas, raising the temperature of the exhaust pipe.

When a coat is formed again on the surface of the by-products, the temperature of the exhaust pipe starts to drop again. Thereafter, each time the exhaust pipe is hit, the coat is split, by-products are exposed between the pieces of the coat, the exposed by-products react with the cleaning gas, and the temperature of the exhaust pipe rises.

In the vapor phase growth method of the second embodiment, the first exhaust pipe 18 is hit from the outside by using the vibration device 42 while supplying the cleaning gas. By hitting the first exhaust pipe 18 from the outside, the first exhaust pipe 18 moves. As the first exhaust pipe 18 moves, the surface of the by-product 40 deposited in the first exhaust pipe 18 moves. Due to the movement of the surface of the by-product 40, even if a coat is formed on the surface of the by-product, the coat is immediately split. Accordingly, the reaction between the cleaning gas and the by-product 40 is promoted. Therefore, the by-product 40 can be effectively removed. In addition, as a method of applying vibration to the exhaust pipe, a method of hitting from the outside with a vibration device has been described. However, the vibration device is not particularly limited as long as vibration can be applied. The vibration device only needs to be able to move the pipe quickly by shaking or vibrating the exhaust pipe.

As described above, according to the vapor phase growth method and the vapor phase growth apparatus of the second embodiment, it is possible to effectively remove by-products deposited in the exhaust pipe at the time of forming the silicon carbide film.

### (Third Embodiment)

A vapor phase growth method of a third embodiment is different from the vapor phase growth method of the second embodiment in that, when removing by-products, a first portion is vibrated by hitting a storage portion provided in the first portion from the outside. In addition, the vapor phase growth apparatus of the third embodiment is different from the vapor phase growth apparatus of the second embodiment in that the exhaust pipe includes a storage portion and the vibration device hits the storage portion.

Hereinafter, the description of a part of the content overlapping the second embodiment will be omitted.

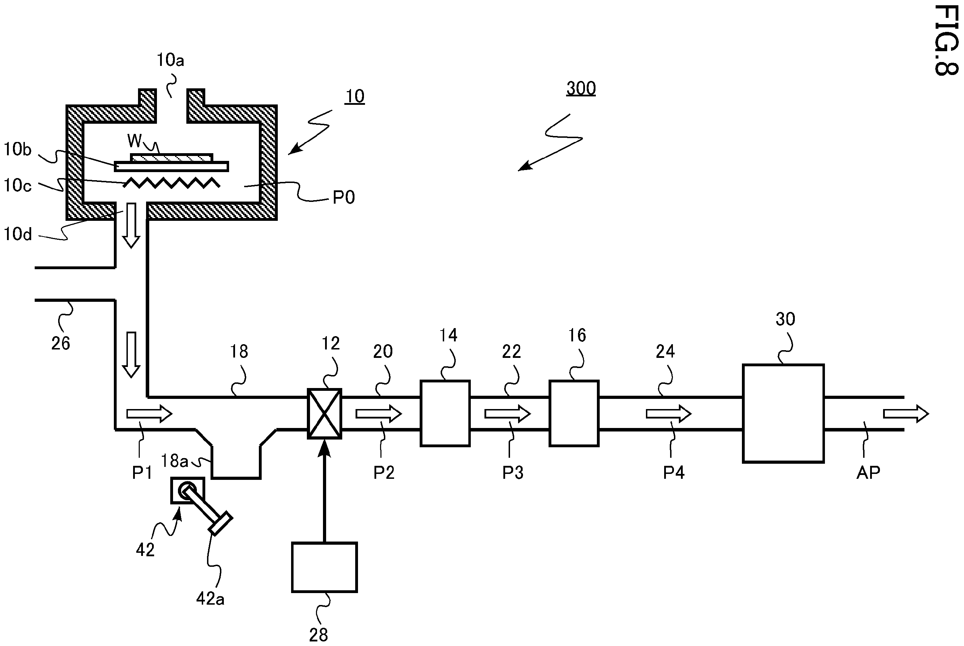

Fig. 8 is a schematic diagram of an example of the vapor phase growth apparatus of the third embodiment. An example of the vapor phase growth apparatus of the third embodiment is a vapor phase growth apparatus 300 for forming a silicon carbide film.

The vapor phase growth apparatus 300 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, a pressure control unit 28, and a vibration device 42. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24. The first exhaust pipe 18 includes a storage portion 18a.

The storage portion 18a has a function of storing by-products deposited in the first exhaust pipe 18 during the formation of a silicon carbide film.

The vibration device 42 has a function of hitting the storage portion 18a of the first exhaust pipe 18 from the outside. The vibration device 42 hits the storage portion 18a at a predetermined period and with a predetermined weight, for example. The vibration device 42 hits the storage portion 18a from the outside by using the hammer portion 42a provided in the vibration device 42.

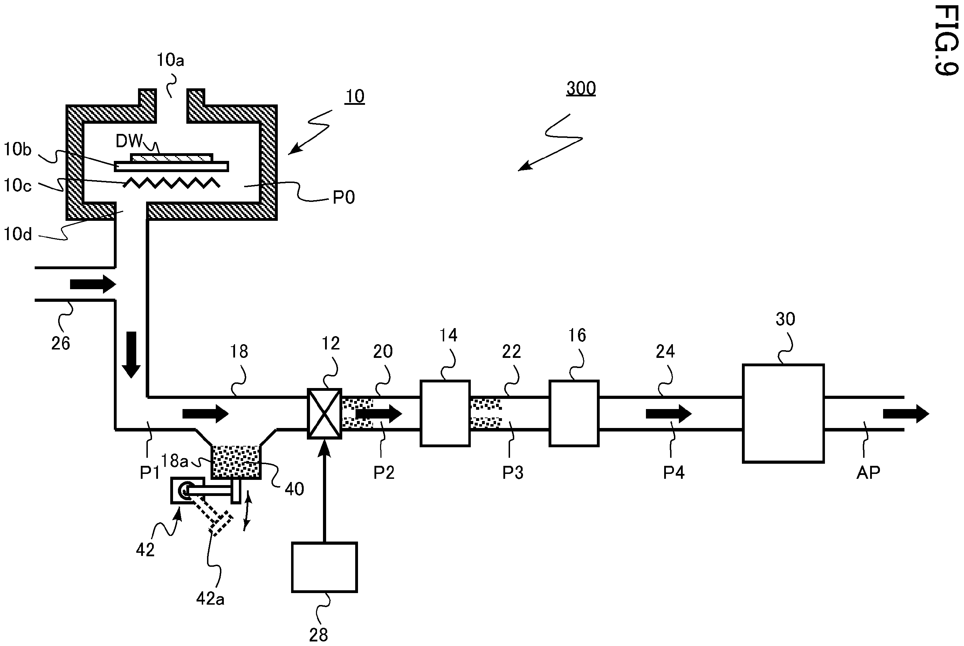

Fig. 9 is an explanatory diagram of the vapor phase growth method of the third embodiment.

In the vapor phase growth method of the third embodiment, similar to the vapor phase growth method of the second embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

In the vapor phase growth method of the third embodiment, the storage portion 18a of the first exhaust pipe 18 is hit from the outside by using the vibration device 42 while supplying the cleaning gas. The hammer portion 42a of the vibration device 42 hits the storage portion 18a at a predetermined period and with a predetermined weight, for example.

By hitting the storage portion 18a from the outside using the vibration device 42 while supplying the cleaning gas, the storage portion 18a moves. By hitting the storage portion 18a from the outside, for example, the storage portion 18a vibrates. By hitting the storage portion 18a from the outside, for example, the storage portion 18a moves.

By hitting the storage portion 18a from the outside using the vibration device 42 while supplying the cleaning gas, the surface of the by-product 40 accumulated in the storage portion 18a moves. For example, the surface of the by-product 40 accumulated in the storage portion 18a vibrates.

In the vapor phase growth method of the third embodiment, by hitting the storage portion 18a from the outside using the vibration device 42 while supplying the cleaning gas, the surface of the by-product 40 accumulated in the storage portion 18a moves. Due to the movement of the surface of the by-product 40, even if a coat that suppresses the reaction between the cleaning gas and the by-product 40 is formed on the surface of the by-product 40, the coat is immediately split. Accordingly, the reaction between the cleaning gas and the by-product 40 is promoted. Therefore, the by-product 40 can be effectively removed.

In order to increase the efficiency of storing the by-product 40, as illustrated in Fig. 8, it is preferable to provide an inclination toward the storage portion 18a in the first exhaust pipe 18. In addition, in order to increase the efficiency of storing the by-product 40, it is preferable to provide a cooler (not illustrated) in the first exhaust pipe 18 in the vicinity of the storage portion 18a.

As described above, according to the vapor phase growth method and the vapor phase growth apparatus of the third embodiment, it is possible to effectively remove by-products deposited in the exhaust pipe at the time of forming the silicon carbide film.

### (Fourth Embodiment)

A vapor phase growth method of a fourth embodiment is different from the vapor phase growth method of the third embodiment in that the first portion is shaken when by-products are removed. In addition, the vapor phase growth apparatus of the fourth embodiment is different from the vapor phase growth apparatus of the third embodiment in that the mechanism for moving the surface of by-products deposited in the exhaust pipe is a swing device that swings the exhaust pipe.

Hereinafter, the description of a part of the content overlapping the third embodiment will be omitted.

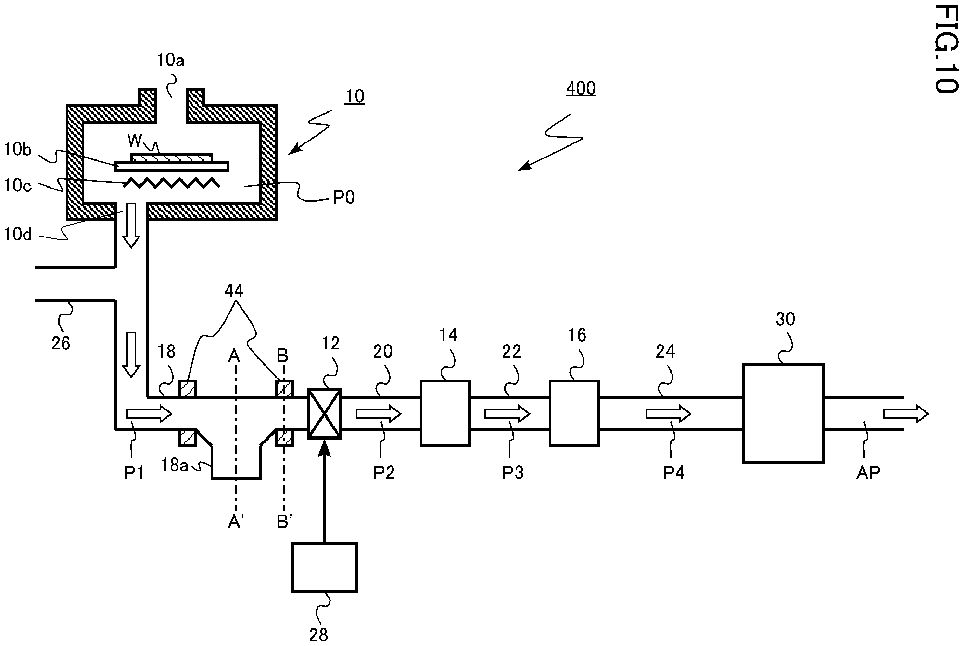

Fig. 10 is a schematic diagram of an example of the vapor phase growth apparatus of the fourth embodiment. An example of the vapor phase growth apparatus of the fourth embodiment is a vapor phase growth apparatus 400 for forming a silicon carbide film.

The vapor phase growth apparatus 400 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, a pressure control unit 28, and a swing device 44. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24. The first exhaust pipe 18 includes a storage portion 18a.

The storage portion 18a has a function of storing by-products deposited in the first exhaust pipe 18 during the formation of a silicon carbide film.

The swing device 44 has a function of swinging the storage portion 18a of the first exhaust pipe 18.

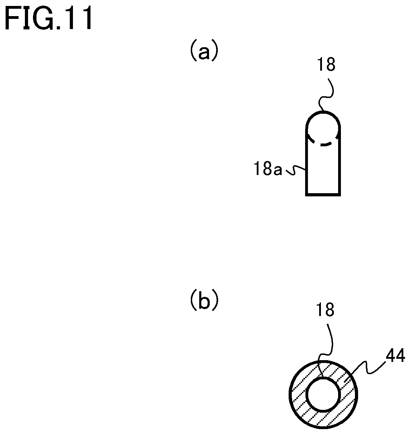

Fig. 11 is a schematic cross-sectional view of a part of the vapor phase growth apparatus of the fourth embodiment. Fig. 11 is a schematic cross-sectional view of the first exhaust pipe 18. Fig. 11(a) is a cross-sectional view taken along the line AA' of Fig. 10. Fig. 11B is a BB' cross section of Fig. 10.

The swing device 44 can swing the storage portion 18a in the circumferential direction of the first exhaust pipe 18 by using, for example, a bidirectional rotary motor capable of switching the rotation direction as a driving source.

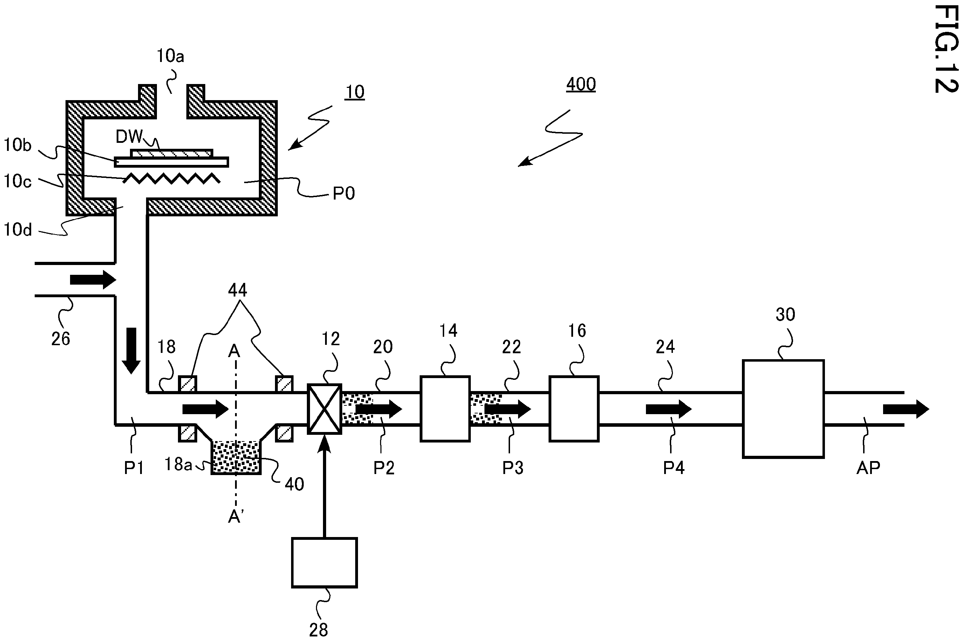

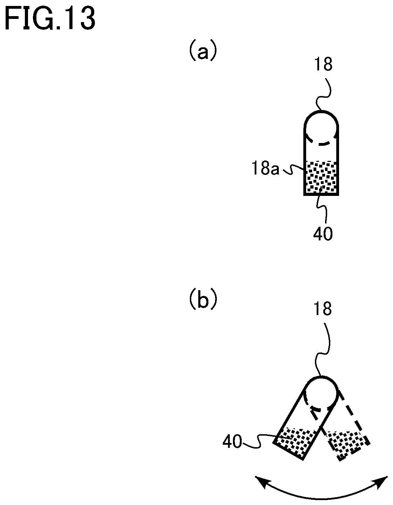

Figs. 12 and 13 are explanatory diagrams of the vapor phase growth method of the fourth embodiment. Fig. 13 is a schematic cross-sectional view of the first exhaust pipe 18. Fig. 13 is a cross-sectional view taken along the line AA' of Fig. 12.

In the vapor phase growth method of the fourth embodiment, similar to the vapor phase growth method of the third embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

In the vapor phase growth method of the fourth embodiment, the storage portion 18a of the first exhaust pipe 18 is swung by using the swing device 44 while supplying the cleaning gas. For example, as illustrated in Fig. 13(b), the storage portion 18a is swung in the circumferential direction of the first exhaust pipe 18 by using the swing device 44.

By swinging the storage portion 18a using the swing device 44, the surface of the by-product 40 accumulated in the storage portion 18a moves. Due to the movement of the surface of the by-product 40 accumulated in the storage portion 18a, even if a coat that suppresses the reaction between the cleaning gas and the by-product 40 is formed on the surface of the by-product 40, the coat is immediately split. Accordingly, the reaction between the cleaning gas and the by-product 40 is promoted. Therefore, the by-product 40 can be effectively removed.

As described above, according to the vapor phase growth method and the vapor phase growth apparatus of the fourth embodiment, it is possible to effectively remove by-products deposited in the exhaust pipe at the time of forming the silicon carbide film.

### (Fifth Embodiment)

A vapor phase growth method of a fifth embodiment is different from the vapor phase growth method of the third embodiment in that the surface of by-products is moved by stirring the by-products when removing the by-products. In addition, the vapor phase growth apparatus of the fifth embodiment is different from the vapor phase growth apparatus of the third embodiment in that the mechanism for moving the surface of by-products deposited in the exhaust pipe is a stirring device for stirring the by-products.

Hereinafter, the description of a part of the content overlapping the third embodiment will be omitted.

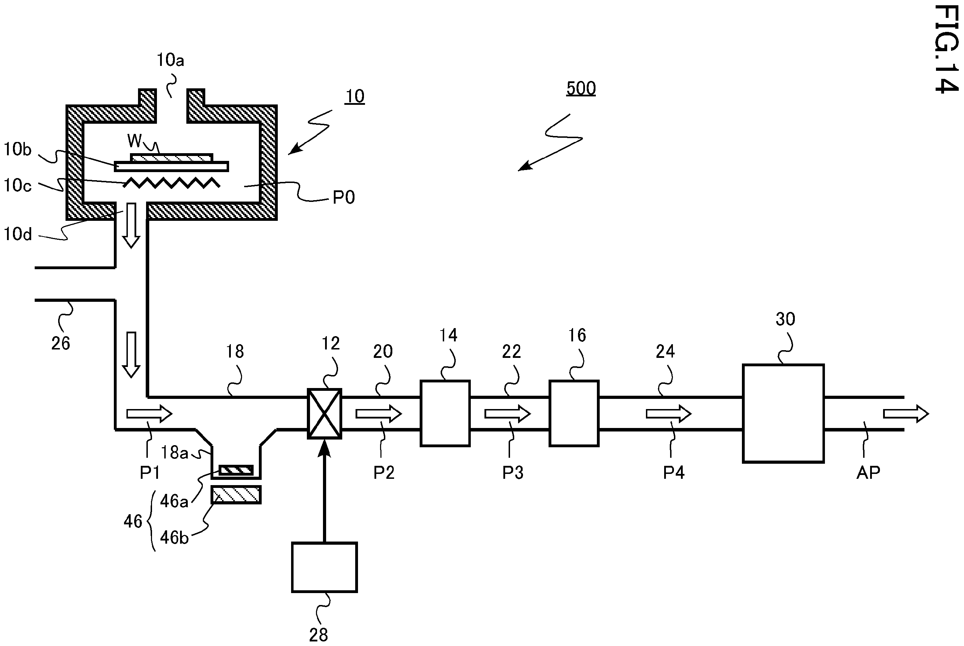

Fig. 14 is a schematic diagram of an example of the vapor phase growth apparatus of the fifth embodiment. An example of the vapor phase growth apparatus of the fifth embodiment is a vapor phase growth apparatus 500 for forming a silicon carbide film.

The vapor phase growth apparatus 500 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, a pressure control unit 28, and a stirring device 46. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24. The first exhaust pipe 18 includes a storage portion 18a.

The storage portion 18a has a function of storing by-products deposited in the first exhaust pipe 18 during the formation of a silicon carbide film.

The stirring device 46 has a function of stirring by-products accumulated in the storage portion 18a of the first exhaust pipe 18. The stirring device 46 is a magnetic stirrer having a stirring bar 46a and a driving unit 46b.

The stirring bar 46a includes a bar magnet. The driving unit 46b has a magnet and a motor for rotating the magnet. The stirring bar 46a rotates due to the rotation of the magnet of the driving unit 46b.

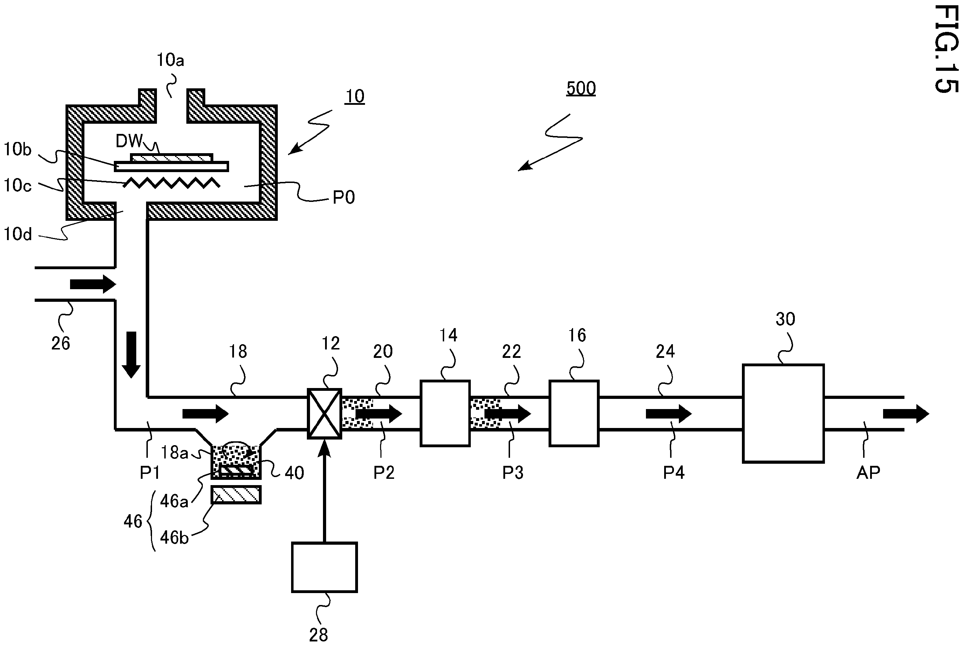

Fig. 15 is an explanatory diagram of the vapor phase growth method of the fifth embodiment.

In the vapor phase growth method of the fifth embodiment, similar to the vapor phase growth method of the third embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

In the vapor phase growth method of the fifth embodiment, the by-product 40 accumulated in the storage portion 18a is stirred by using the stirring device 46 while supplying the cleaning gas. The rotation of the magnet of the driving unit 46b causes the stirring bar 46a to rotate, thereby stirring the by-product 40 accumulated in the storage portion 18a.

In the vapor phase growth method of the fifth embodiment, the surface of the by-product 40 is moved by stirring the by-product 40 accumulated in the storage portion 18a while supplying the cleaning gas. Due to the movement of the surface of the by-product 40 accumulated in the storage portion 18a, even if a coat that suppresses the reaction between the cleaning gas and the by-product 40 is formed on the surface of the by-product 40, the coat is immediately split. Accordingly, the reaction between the cleaning gas and the by-product 40 is promoted. Therefore, the by-product 40 can be effectively removed.

As described above, according to the vapor phase growth method and the vapor phase growth apparatus of the fifth embodiment, the by-products deposited in the exhaust pipe at the time of forming the silicon carbide film can be effectively removed.

### (Sixth Embodiment)

A vapor phase growth apparatus of a sixth embodiment is different from the vapor phase growth apparatus of the fifth embodiment in that the configuration of the stirring device is different.

Hereinafter, the description of a part of the content overlapping the fifth embodiment will be omitted.

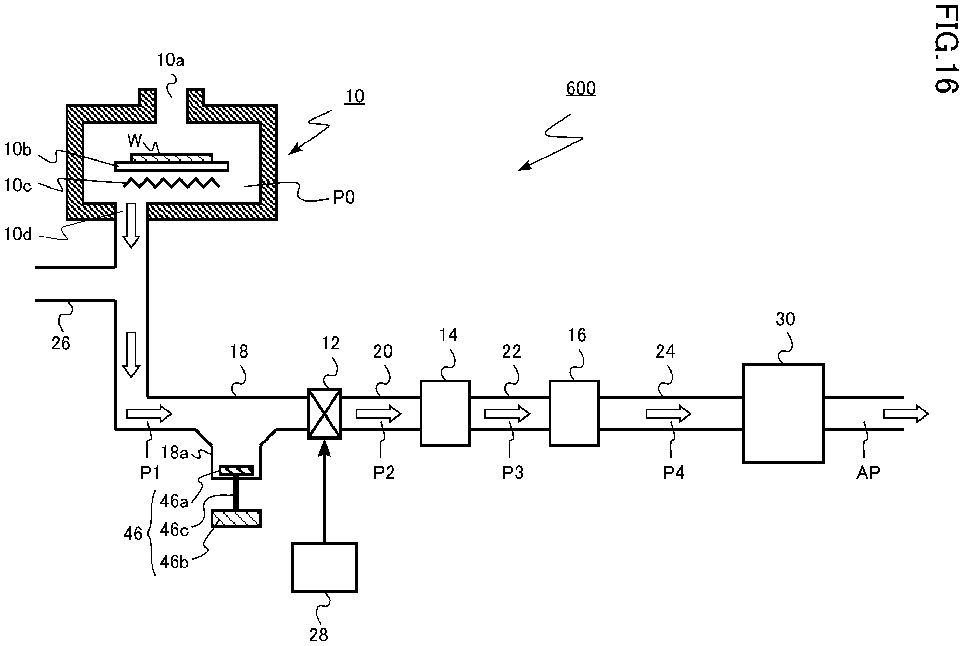

Fig. 16 is a schematic diagram of an example of the vapor phase growth apparatus of the sixth embodiment. An example of the vapor phase growth apparatus of the sixth embodiment is a vapor phase growth apparatus 600 for forming a silicon carbide film.

A stirring device 46 has a function of stirring by-products accumulated in the storage portion 18a of the first exhaust pipe 18. The stirring device 46 has a stirring bar 46a, a driving unit 46b, and a rotating shaft 46c.

The stirring bar 46a is fixed to the rotating shaft 46c. The driving unit 46b has a motor for rotating the rotating shaft 46c. By rotating the rotating shaft 46c by the driving unit 46b, the stirring bar 46a rotates.

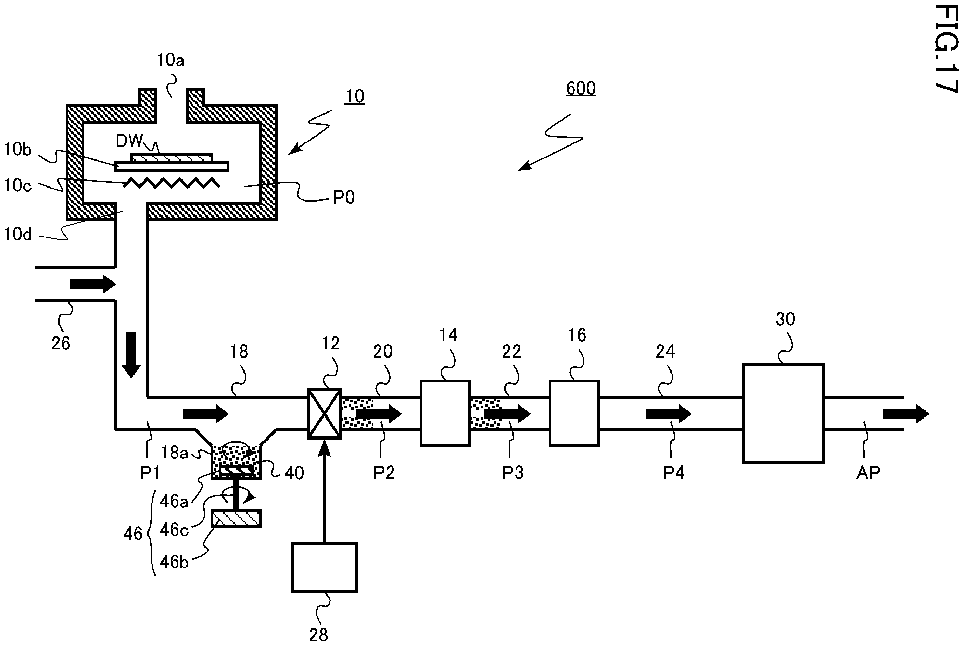

Fig. 17 is an explanatory diagram of the vapor phase growth method of the sixth embodiment.

In the vapor phase growth method of the sixth embodiment, similar to the vapor phase growth method of the fifth embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

In the vapor phase growth method of the sixth embodiment, the by-product 40 accumulated in the storage portion 18a is stirred by using the stirring device 46 while supplying the cleaning gas. The driving unit 46b rotates the stirring bar 46a to stir the by-product 40 accumulated in the storage portion 18a.

In the vapor phase growth method of the sixth embodiment, the surface of the by-product 40 is moved by stirring the by-product 40 accumulated in the storage portion 18a while supplying the cleaning gas. Due to the movement of the surface of the by-product 40 accumulated in the storage portion 18a, even if a coat that suppresses the reaction between the cleaning gas and the by-product 40 is formed on the surface of the by-product 40, the coat is immediately split. Accordingly, the reaction between the cleaning gas and the by-product 40 is promoted. Therefore, the by-product 40 can be effectively removed.

As described above, according to the vapor phase growth method and the vapor phase growth apparatus of the sixth embodiment, it is possible to effectively remove by-products deposited in the exhaust pipe at the time of forming the silicon carbide film.

### (Seventh Embodiment)

A vapor phase growth method of a seventh embodiment is different from the vapor phase growth method of the third embodiment in that the storage portion is heated when by-products are removed.

In addition, the vapor phase growth apparatus of the seventh embodiment includes a reactor, an exhaust pump for discharging a gas from the reactor, an exhaust pipe that is provided between the reactor and the exhaust pump and includes a storage portion for storing by-products, and a heater for heating the storage portion.

Hereinafter, the description of a part of the content overlapping the third embodiment will be omitted.

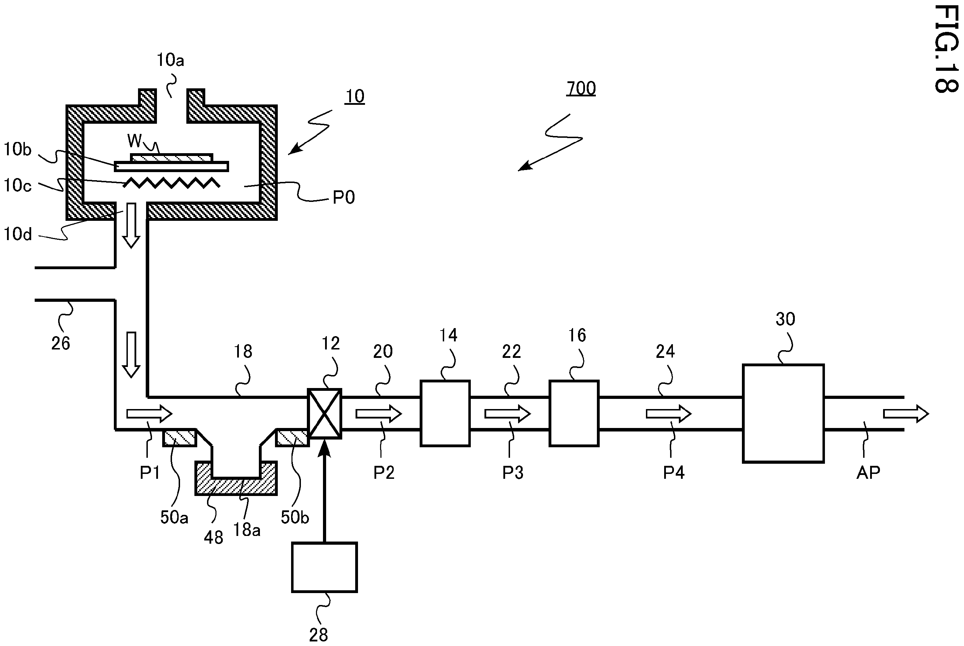

Fig. 18 is a schematic diagram of an example of the vapor phase growth apparatus of the seventh embodiment. An example of the vapor phase growth apparatus of the seventh embodiment is a vapor phase growth apparatus 700 for forming a silicon carbide film.

The vapor phase growth apparatus 700 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, a pressure control unit 28, a heater 48, a first cooler 50a, and a second cooler 50b. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24. The first exhaust pipe 18 includes a storage portion 18a.

The storage portion 18a has a function of storing by-products deposited in the first exhaust pipe 18 during the formation of a silicon carbide film.

The heater 48 is provided so as to surround the storage portion 18a, for example. The heater 48 has a function of heating the storage portion 18a. With the heater 48, for example, the storage portion 18a can be heated to a temperature of 150°C or higher and 300°C or lower. The temperature of the storage portion 18a can be measured by, for example, a thermometer provided outside the storage portion 18a.

The first cooler 50a is provided in the first exhaust pipe 18 on the reactor 10 side of the storage portion 18a. The second cooler 50b is provided in the first exhaust pipe 18 on the exhaust pump 14 side of the storage portion 18a.

The first cooler 50a and the second cooler 50b have a function of cooling the first exhaust pipe 18 on the upstream side and the downstream side of the storage portion 18a. The first cooler 50a and the second cooler 50b are, for example, water-cooled coolers.

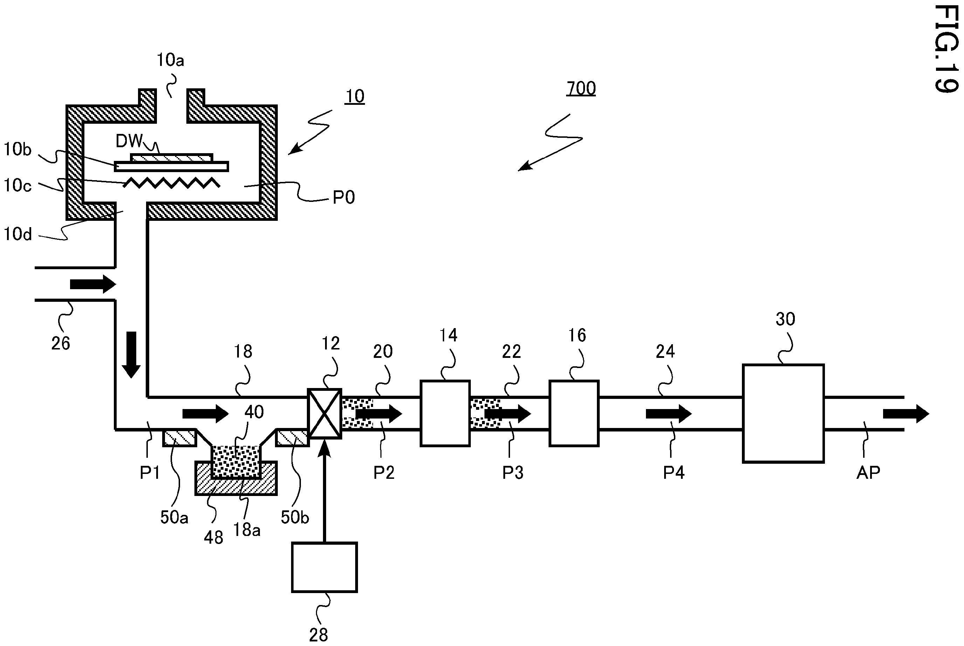

Fig. 19 is an explanatory diagram of the vapor phase growth method of the seventh embodiment.

In the vapor phase growth method of the seventh embodiment, similar to the vapor phase growth method of the third embodiment, the wafer W is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

The storage portion 18a is heated by using the heater 48 while supplying the cleaning gas. By heating the storage portion 18a, the by-product 40 accumulated in the storage portion 18a is heated.

In addition, while supplying the cleaning gas, the first exhaust pipe 18 on the upstream side and the downstream side of the storage portion 18a is cooled by using the first cooler 50a and the second cooler 50b.

In the vapor phase growth method of the seventh embodiment, the reaction between the cleaning gas and the by-product 40 is promoted by heating the by-product 40 while supplying the cleaning gas. Therefore, the by-product 40 can be effectively removed. In particular, when a substance having a carbon-carbon bond is produced, removal at a low temperature is difficult. Therefore, raising the temperature is effective in removing the by-product 40.

In addition, in the vapor phase growth method of the seventh embodiment, the first exhaust pipe 18 on the upstream side and the downstream side of the storage portion 18a is cooled by using the first cooler 50a and the second cooler 50b while supplying the cleaning gas. By cooling the front and rear of the storage portion 18a, which becomes hot due to heating by the heater 48, it is possible to protect a member having low heat resistance provided in the exhaust pipe or the like.

From the viewpoint of promoting the reaction between the cleaning gas and the by-product 40, the temperature of the storage portion 18a is preferably 150°C or higher, more preferably 200°C or higher, and even more preferably 250°C or higher. In addition, from the viewpoint of protecting the member having low heat resistance, the temperature of the storage portion 18a is preferably 300°C or lower.

As described above, according to the vapor phase growth method and the vapor phase growth apparatus of the seventh embodiment, it is possible to effectively remove by-products deposited in the exhaust pipe at the time of forming the silicon carbide film.

### (Eighth Embodiment)

A vapor phase growth method of an eighth embodiment is different from the vapor phase growth method of the second embodiment in that, before loading the second substrate into the reactor after removing by-products, the storage portion is detached and the by-products remaining in the storage portion are removed by using a chemical solution.

In addition, the vapor phase growth apparatus of the eighth embodiment is different from the vapor phase growth apparatus of the second embodiment in that the storage portion can be detached from the first portion.

Hereinafter, the description of a part of the content overlapping the second embodiment will be omitted.

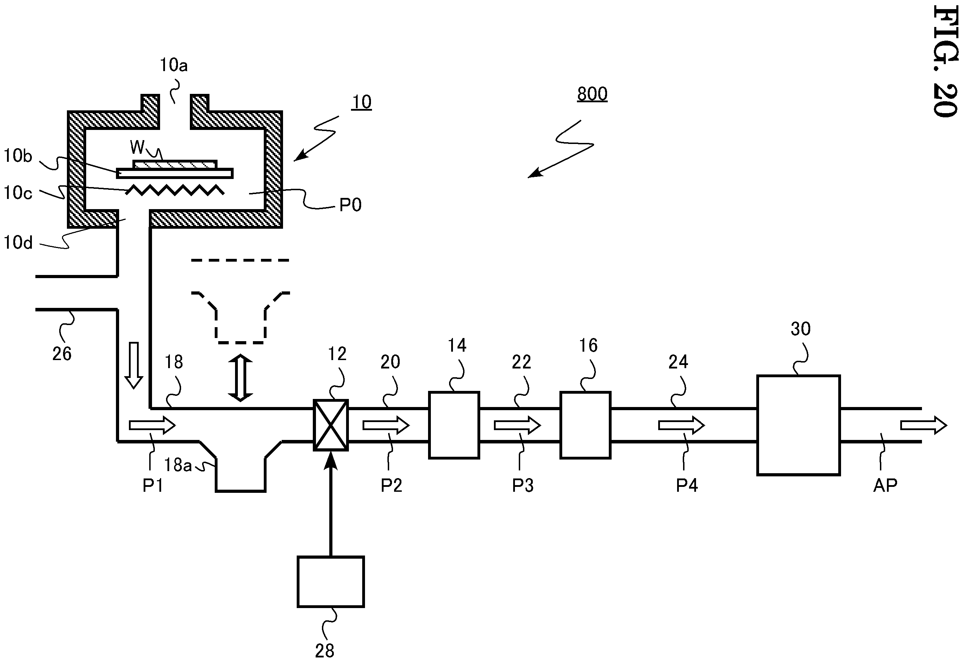

Fig. 20 is a schematic diagram of an example of the vapor phase growth apparatus of the eighth embodiment. An example of the vapor phase growth apparatus of the eighth embodiment is a vapor phase growth apparatus 800 for forming a silicon carbide film.

The vapor phase growth apparatus 800 includes a reactor 10, a pressure control valve 12, an exhaust pump 14, an abatement system 16, a first exhaust pipe 18 (first portion), a second exhaust pipe 20 (second portion), a third exhaust pipe 22 (third portion), a fourth exhaust pipe 24, a cleaning gas supply pipe 26, and a pressure control unit 28. The reactor 10 has a gas supply port 10a, a susceptor 10b, a heater 10c, and a gas exhaust port 10d. An exhaust duct 30 is connected to the fourth exhaust pipe 24. The exhaust pipe includes the first exhaust pipe 18, the second exhaust pipe 20, the third exhaust pipe 22, and the fourth exhaust pipe 24. The first exhaust pipe 18 includes a storage portion 18a.

The storage portion 18a has a function of storing by-products deposited in the first exhaust pipe 18 during the formation of a silicon carbide film. The storage portion 18a can be detached from the first exhaust pipe 18.

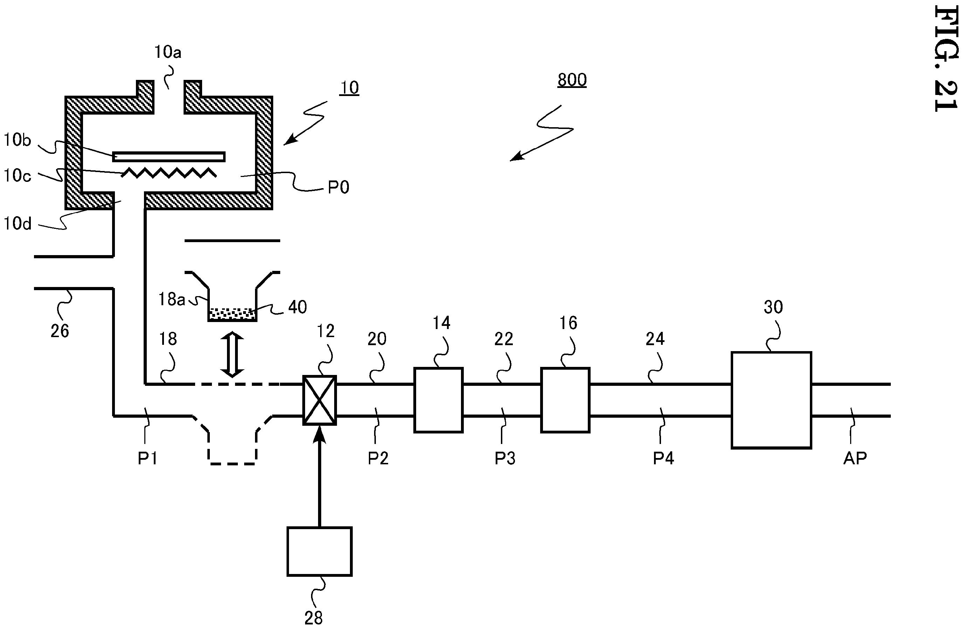

Fig. 21 is an explanatory diagram of the vapor phase growth method of the eighth embodiment.

In the vapor phase growth method of the eighth embodiment, similar to the vapor phase growth method of the second embodiment, the wafer W (first substrate) is unloaded to the outside of the reactor 10, and then the dummy wafer DW is loaded into the reactor 10 and placed on the susceptor 10b. Then, the cleaning gas is supplied from the cleaning gas supply pipe 26 into the first exhaust pipe 18, and the purge gas is supplied from the gas supply port 10a to the first exhaust pipe 18 through the inside of the reactor 10. The cleaning gas is, for example, chlorine trifluoride (ClF₃) gas diluted with nitrogen.

After removing the by-product 40 by supplying the cleaning gas, the storage portion 18a is detached from the first exhaust pipe 18 before loading the wafer W (second substrate) into the reactor 10. Then, the by-product 40 remaining in the storage portion 18a is removed by using a chemical solution.

The chemical solution is, for example, an acidic solution. The chemical solution is, for example, hydrofluoric acid or nitric acid.

Thereafter, the storage portion 18a is attached to the first exhaust pipe 18, and the wafer W (second substrate) is loaded into the reactor 10.

In the vapor phase growth method of the eighth embodiment, it is possible to effectively remove the by-product 40 by removing the by-product 40 remaining in the storage portion 18a using the chemical solution. In particular, when a substance having a carbon-carbon bond is produced, removal using a cleaning gas is difficult. Therefore, it is effective to remove by-products with a chemical solution.

As described above, according to the vapor phase growth method and the vapor phase growth apparatus of the eighth embodiment, it is possible to effectively remove by-products deposited in the exhaust pipe at the time of forming the silicon carbide film.

In the first to eighth embodiments and the modification examples, the vertical single wafer type epitaxial apparatus that forms a film on each wafer has been described as an example. However, the vapor phase growth apparatus is not limited to the single wafer type epitaxial apparatus. For example, the invention can also be applied to a planetary type CVD apparatus for simultaneously forming a film on a plurality of revolving wafers, a horizontal epitaxial apparatus, and the like.

In the first to eighth embodiments and the modification examples, a case where the silicon (Si) source gas and the carbon (C) source gas are mixed and supplied to the reactor 10 from one gas supply port 10a when forming the silicon carbide film has been described as an example. However, for example, the silicon (Si) source gas and the carbon (C) source gas can be supplied to the reactor 10 from different gas supply ports 10a.

Cleaning of the vapor phase growth apparatuses of the first to eighth embodiments and the modification examples does not have to be performed each time the silicon carbide film is formed. For example, the vapor phase growth apparatuses may be cleaned after the silicon carbide film is formed on a plurality of substrates.

In the second to fourth embodiments, the form in which the first exhaust pipe 18 (first portion) is vibrated has been described as an example. However, it is possible to apply a form in which the second exhaust pipe 20 (second portion) is vibrated or a form in which both the first exhaust pipe 18 (first portion) and the second exhaust pipe 20 (second portion) are vibrated.

In the second to eighth embodiments, the form in which the first exhaust pipe 18 (first portion) includes the storage portion 18a has been described as an example. However, it is possible to apply a form in which the second exhaust pipe 20 (second portion) includes a storage portion or a form in which both the first exhaust pipe 18 (first portion) and the second exhaust pipe 20 (second portion) include a storage portion.

In the first to eighth embodiments and the modification examples, the description of parts that are not directly required for the description of the invention, such as the apparatus configuration or the growth method, is omitted. However, the required apparatus configuration, growth method, and the like can be appropriately selected and used. In addition, all vapor phase growth methods and vapor phase growth apparatuses that include the elements of the invention and that can be appropriately redesigned by those skilled in the art are included in the scope of the invention. The scope of the invention is defined by the scope of claims and the scope of their equivalents.

### EXPLANATIONS OF LETTERS OR NUMERALS

- 10: REACTOR
- 10a: GAS SUPPLY PORT
- 10b: SUSCEPTOR
- 10c: HEATER
- 10d: GAS EXHAUST PORT
- 12: PRESSURE CONTROL VALVE
- 14: EXHAUST PUMP
- 16: ABATEMENT SYSTEM
- 18: FIRST EXHAUST PIPE (FIRST PORTION)
- 18a: STORAGE PORTION
- 20: SECOND EXHAUST PIPE (SECOND PORTION)
- 22: THIRD EXHAUST PIPE (THIRD PORTION)
- 24: FOURTH EXHAUST PIPE
- 26: CLEANING GAS SUPPLY PIPE
- 28: PRESSURE CONTROL UNIT
- 30: EXHAUST DUCT
- 40: BY-PRODUCT
- 42: VIBRATION DEVICE
- 42a: HAMMER PORTION
- 44: SWING DEVICE
- 46: STIRRING DEVICE
- 46a: STIRRING BAR
- 46b: DRIVING UNIT
- 46c: ROTATING SHAFT
- 48: HEATER
- 50a: FIRST COOLER
- 50b: SECOND COOLER
- 100: VAPOR PHASE GROWTH APPARATUS
- 200: VAPOR PHASE GROWTH APPARATUS
- 300: VAPOR PHASE GROWTH APPARATUS
- 400: VAPOR PHASE GROWTH APPARATUS
- 500: VAPOR PHASE GROWTH APPARATUS
- 600: VAPOR PHASE GROWTH APPARATUS
- 700: VAPOR PHASE GROWTH APPARATUS
- 800: VAPOR PHASE GROWTH APPARATUS
- AP: ATMOSPHERIC PRESSURE
- P0: PRESSURE IN REACTOR
- P1: FIRST PRESSURE
- P2: SECOND PRESSURE
- P3: THIRD PRESSURE
- P4: FOURTH PRESSURE
- W: WAFER (FIRST SUBSTRATE, SECOND SUBSTRATE)
- DW: DUMMY WAFER

## Claims

1. A vapor phase growth method using a vapor phase growth apparatus including a reactor, an exhaust pump discharging a gas from the reactor, a pressure control valve adjusting a pressure in the reactor, and an exhaust pipe having a first portion provided between the reactor and the pressure control valve and a second portion provided between the pressure control valve and the exhaust pump, the method comprising:
loading a first substrate into the reactor, heating the first substrate to a predetermined temperature, supplying a process gas at a predetermined flow rate, and forming a silicon carbide film on a surface of the first substrate and depositing a by-product containing carbon in at least one of the first portion and the second portion by adjusting a pressure in the reactor to a predetermined pressure by controlling the pressure control valve;
unloading the first substrate from the reactor;
removing the by-product by supplying a gas including a gas containing fluorine to at least a part of the exhaust pipe by controlling a pressure in the exhaust pipe; and
loading a second substrate into the reactor to form a silicon carbide film on a surface of the second substrate after removing the by-product.

2. The vapor phase growth method according to claim 1, wherein the gas containing fluorine is chlorine trifluoride.

3. The vapor phase growth method according to claim 1,
wherein the exhaust pipe has an abatement system and a third portion provided between the exhaust pump and the abatement system, and
when supplying a gas including the gas containing fluorine, a pressure in the third portion is controlled to be 95% or more of atmospheric pressure.

4. The vapor phase growth method according to claim 1,
wherein, when supplying a gas including the gas containing fluorine, an opening degree of the pressure control valve is adjusted based on a pressure in the first portion.

5. The vapor phase growth method according to claim 1, wherein the process gas contains chlorine.

6. The vapor phase growth method according to claim 1, wherein, when removing the by-product, a surface of the by-product is moved.

7. The vapor phase growth method according to claim 6, wherein the surface of the by-product is moved by vibrating at least one of the first portion and the second portion.

8. The vapor phase growth method according to claim 7, wherein at least one of the first portion and the second portion is vibrated by giving an external impact to at least one of the first portion and the second portion.

9. The vapor phase growth method according to claim 6, wherein the surface of the by-product is moved by stirring the by-product.

10. The vapor phase growth method according to claim 1, wherein at least one of the first portion and the second portion includes a storage portion for storing the by-product, and the storage portion is heated when removing the by-product.

11. The vapor phase growth method according to claim 10, wherein at least one of the first portion and the second portion is heated to 150°C or higher.

12. The vapor phase growth method according to claim 10, wherein the exhaust pipe on the reactor side of the storage portion and the exhaust pipe on the exhaust pump side of the storage portion are cooled.

13. The vapor phase growth method according to claim 1,
wherein at least one of the first portion and the second portion includes a storage portion storing the by-product, and
before loading the second substrate into the reactor after removing the by-product, the storage portion is detached and the by-product remaining in the storage portion is removed by using a chemical solution.

14. A vapor phase growth apparatus, comprising:
a reactor;
an exhaust pump discharging a gas from the reactor;
an exhaust pipe provided at least between the reactor and the exhaust pump; and
a mechanism moving a surface of a by-product deposited in the exhaust pipe.

15. The vapor phase growth apparatus according to claim 14,
wherein the mechanism is a vibration device for vibrating the exhaust pipe.

16. The vapor phase growth apparatus according to claim 15,
wherein the exhaust pipe includes a storage portion, and the vibration device gives vibration to the storage portion.

17. The vapor phase growth apparatus according to claim 14,
wherein the mechanism is a swing device swinging the exhaust pipe.

18. The vapor phase growth apparatus according to claim 14,
wherein the mechanism is a stirring device stirring the by-product.

19. A vapor phase growth apparatus, comprising:
a reactor;
an exhaust pump for discharging a gas from the reactor;
an exhaust pipe provided at least between the reactor and the exhaust pump and including a storage portion storing a by-product; and
a heater for heating the storage portion.

20. The vapor phase growth apparatus according to claim 19, further comprising:
a first cooler cooling the exhaust pipe on the reactor side of the storage portion; and
a second cooler cooling the exhaust pipe on the exhaust pump side of the storage portion.

## Amended claims

Statement under Art. 19.1 PCT
**1.** (Amended) A vapor phase growth method using a vapor phase growth apparatus including a reactor, an exhaust pump discharging a gas from the reactor, a pressure control valve adjusting a pressure in the reactor, and an exhaust pipe having a first portion provided between the reactor and the pressure control valve and a second portion provided between the pressure control valve and the exhaust pump, the method comprising:
loading a first substrate into the reactor, heating the first substrate to a predetermined temperature, supplying a process gas at a predetermined flow rate, and forming a silicon carbide film on a surface of the first substrate and depositing a by-product containing carbon in at least the second portion by adjusting a pressure in the reactor to a predetermined pressure by controlling the pressure control valve;
unloading the first substrate from the reactor;
removing the by-product by supplying a gas including a gas containing fluorine to at least the second portion by controlling a pressure in the exhaust pipe; and
loading a second substrate into the reactor to form a silicon carbide film on a surface of the second substrate after the removing the by-product.

**2.** The vapor phase growth method according to claim 1,
 wherein the gas containing fluorine is chlorine trifluoride.

**3.** (Amended) The vapor phase growth method according to claim 1,
wherein the exhaust pipe has an abatement system and a third portion provided between the exhaust pump and the abatement system, and
when supplying a gas including the gas containing fluorine, a pressure in the third portion is controlled to be 95% or more of atmospheric pressure and be a negative pressure with respect to the atmospheric pressure.

**4.** The vapor phase growth method according to claim 1,
 wherein, when supplying a gas including the gas containing fluorine, an opening degree of the pressure control valve is adjusted based on a pressure in the first portion.

**5.** The vapor phase growth method according to claim 1,
 wherein the process gas contains chlorine.

**6.** The vapor phase growth method according to claim 1,
 wherein, in the removing the by-product, a surface of the by-product is moved.

**7.** The vapor phase growth method according to claim 6,
 wherein the surface of the by-product is moved by vibrating at least one of the first portion and the second portion.

**8.** (Amended) The vapor phase growth method according to claim 7,
 wherein at least the second portion is vibrated by giving an external impact to at least one of the first portion and the second portion.

**9.** The vapor phase growth method according to claim 6,
 wherein the surface of the by-product is moved by stirring the by-product.

**10.** The vapor phase growth method according to claim 1,
 wherein at least one of the first portion and the second portion includes a storage portion storing the by-product, and the storage portion is heated in the removing the by-product.

**11.** The vapor phase growth method according to claim 10,
 wherein the at least one of the first portion and the second portion is heated to 150°C or higher.

**12.** The vapor phase growth method according to claim 10,
 wherein the exhaust pipe on the reactor side of the storage portion and the exhaust pipe on the exhaust pump side of the storage portion are cooled.

**13.** The vapor phase growth method according to claim 1,
wherein at least one of the first portion and the second portion includes a storage portion storing the by-product, and
before the loading the second substrate into the reactor after the removing the by-product, the storage portion is detached and the by-product remaining in the storage portion is removed by using a chemical solution.

**14.** Deleted)

**15.** Deleted)

**16.** Deleted)

**17.** Deleted)

**18.** Deleted)

**19.** Deleted)

**20.** Deleted)

**21.** Added) A vapor phase growth method using a vapor phase growth apparatus including a reactor, an exhaust pump discharging a gas from the reactor, an abatement system abating the gas discharged from the exhaust pump, a pressure control valve adjusting a pressure in the reactor, and an exhaust pipe having a first portion provided between the reactor and the pressure control valve, a second portion provided between the pressure control valve and the exhaust pump, and a third portion provided between the exhaust pump and the abatement system, the method comprising:
loading a first substrate into the reactor, heating the first substrate to a predetermined temperature, supplying a process gas at a predetermined flow rate, and forming a silicon carbide film on a surface of the first substrate and depositing a by-product containing carbon in at least the third portion by adjusting a pressure in the reactor to a predetermined pressure by controlling the pressure control valve;
unloading the first substrate from the reactor;
removing the by-product by supplying a gas including a gas containing fluorine to at least the third portion by controlling a pressure in the third portion to be 95% or more of atmospheric pressure and be a negative pressure with respect to the atmospheric pressure; and
loading a second substrate into the reactor to form a silicon carbide film on a surface of the second substrate after the removing the by-product.
